# EUROPÄISCHE PATENTSCHRIFT

(11) **EP 3 931 963 B1**
(45) Veröffentlichungstag und Bekanntmachung des Hinweises auf die Patenterteilung: **17.08.2022**
(21) Anmeldenummer: 20704449.6
(22) Anmeldetag: 03.02.2020
(51) Int. Cl.: H03K 17/10, H02M 1/096, H03K 17/567, H02M 1/088, H02M 3/156, H02M 7/5387

(54) **LEISTUNGSELEKTRONISCHE VORRICHTUNG UND VERFAHREN ZUR ELEKTRISCHEN SPANNUNGSVERSORGUNG EINER TREIBERSCHALTUNG EINES LEISTUNGSHALBLEITERSCHALTERS**
POWER ELECTRONICS DEVICE AND METHOD FOR SUPPLYING ELECTRICAL VOLTAGE TO A DRIVER CIRCUIT OF A POWER SEMICONDUCTOR SWITCH
DISPOSITIF ÉLECTRONIQUE DE PUISSANCE ET PROCÉDÉ D'ALIMENTATION EN TENSION ÉLECTRIQUE D'UN CIRCUIT D'ATTAQUE D'UN COMMUTATEUR SEMI-CONDUCTEUR DE PUISSANCE

(30) Priorität: 25.02.2019 DE 102019104652
(43) Veröffentlichungstag der Anmeldung: 05.01.2022
(73) Patentinhaber: SMA Solar Technology AG, 34266 Niestetal (DE)
(72) Erfinder: MUELLER, Burkard, 34123 Kassel (DE)
(86) Internationale Anmeldenummer: PCT/EP2020/052618
(87) Internationale Veröffentlichungsnummer: WO 2020/173667

(56) Entgegenhaltungen:
- CH-A2- 699 884
- DE-A1-102008 047 028
- US-A1- 2018 145 668

## Beschreibung

Die Erfindung bezieht sich auf eine leistungselektronische Vorrichtung, insbesondere einen Stromrichter, mit mindestens einem ersten Leistungshalbleiterschalter. Zur Ansteuerung des ersten Leistungshalbleiterschalters umfasst die leistungselektronische Vorrichtung auch eine Treiberschaltung.

Die Erfindung bezieht sich auch auf ein Verfahren zur elektrischen Spannungsversorgung einer Treiberschaltung eines Leistungshalbleiterschalters.

Bei der leistungselektronischen Vorrichtung kann es sich beispielsweise um einen Tiefsetzsteller, einen Hochsetzsteller, oder einen Hoch-/Tiefsetzsteller oder einen Wechselrichter handeln. Derartige Stromrichter umfassen Leistungshalbleiterschalter, die zur Umwandlung einer eingangsseitig anliegenden Spannung durch den Stromrichter entsprechend geschaltet werden. Zur Ansteuerung der Leistungshalbleiterschalter wird an einen Steuereingang des Leistungshalbleiterschalters ein Steuersignal angelegt. Der Steuereingang kann beispielsweise ein Gate-Anschluss eines IGBTs (Insulated Gate Bipolar Transistor) oder eines MOSFETs (Metal Oxide Semiconductor Field Effect Transistor) sein. Zur Erzeugung von Ansteuersignalen für Leistungshalbleiterschalter werden häufig integrierte Schaltungen -die auch mit Taktgeber oder Signalgeber bezeichnet werden können-, beispielsweise Mikroprozessoren, verwendet. Die von diesen integrierten Schaltungen bereit gestellten Ausgangsströme oder Ausgangsspannungen sind in den meisten Fällen jedoch nicht ausreichend, um einen Leistungshalbleiterschalter direkt anzusteuern. Daher werden Treiberschaltungen zwischen dem Taktgeber und dem Leistungshalbleiterschalter eingesetzt, die aus dem Ansteuersignal des Taktgebers ein Steuersignal mit ausreichender Stromstärke und Spannung erzeugen und dieses an einem Treiberausgang einem Steuereingang des Leistungshalbleiterschalters zur Verfügung stellen. Bei dem Ansteuersignal und dem Steuersignal kann es sich um ein sogenanntes Pulsweitenmoduliertes Ansteuer-/Steuersignal handeln, wobei das Pulsmuster des Ansteuer-/Steuersignals im Taktgeber mittels einer Modulationsgröße und einer Steuergröße erzeugt werden kann. Die Modulationsgröße kann einen periodischen, dreieckförmigen oder sägezahnförmigen Spannungsverlauf aufweisen und die Steuergröße kann einen konstanten Verlauf bei einem der Steuergröße entsprechenden Spannungswert aufweisen. Das Pulsmuster des pulsweitenmodulierte Ansteuersignal kann durch Vergleich von Steuergröße und Modulationsgröße erzeugt werden, wobei der Taktgeber gemäß einem aktuellen Betriebszustand des Stromrichters hinsichtlich einer Frequenz und Höhe der Modulationsgröße und einer Höhe des Steuerwertes gesteuert wird, beispielsweise von einer Steuerung des Stromrichters. Alternativ kann das Steuersignal auch einen festen Tastgrad besitzen, über eine unterlagerte Stromregelung erzeugt werden (current mode) oder in anderer Weise abhängig von Schaltschwellen und/oder festen Ein- oder Auszeiten generiert werden, wobei die Schaltfrequenz auch variabel sein kann. Taktgeber und Treiberschaltung können in einem gemeinsamen Bauteil verbaut sein. Die Leistungshalbleiterschalter können zu ihrem Schutz oder für eine rückwärtsleitende Funktion jeweils eine Bodydiode aufweisen oder eine Diode umfassen, deren Polung einer Bodydiode entspricht.

Sowohl im Betrieb als auch im Anlauffall des elektrischen Geräts müssen seine notwendigen Komponenten, im Falle eines Stromrichters beispielsweise die Steuerung des Stromrichters und Treiberschaltungen seiner Leistungshalbleiterschalter, mit elektrischer Leistung versorgt werden. Im Anlauffall eines Stromrichters kann beispielsweise mindestens zwischen einem ersten und einem zweiten Anschluss eines Eingangs des Stromrichters eine Gleichspannung anliegen, die beispielsweise von einem DC-Generator wie einem Photovoltaik-Modul oder einer Reihenschaltung (String) aus derartigen Modulen bereitgestellt wird. Aus einer derartig anliegenden Gleichspannung kann beispielsweise im Anlauffall eine Versorgung notwendiger Komponenten erfolgen.

Die vorliegende Erfindung betrifft die Versorgung mindestens einer Treiberschaltung der leistungselektronischen Vorrichtung mit elektrischer Spannung. Die vorliegende Erfindung betrifft auch ein Verfahren zur elektrischen Spannungsversorgung einer Treiberschaltung eines Leistungshalbleiterschalters. Derartige Treiberschaltungen für Leistungshalbleiterschalter, wie beispielsweise MOSFETs oder IGBTs, benötigen eine Spannungsversorgung von üblicherweise 10 bis 20 Volt, die auf das Potential des Bezugspotentialanschlusses des Leistungshalbleiterschalters bezogen ist. Bei dem Bezugspotentialanschluss handelt es sich beispielsweise um einen Emitteranschluss bei einem Bipolartransistor oder IGBT oder um einen Sourceanschluss bei einem MOSFET. Insbesondere Treiberschaltungen für Leistungshalbleiterschalter, die bereits vor Anlauf einer Bordnetzversorgung eines Stromrichters funktionieren müssen oder Teil der Bordnetzversorgung sind, sind schwierig zu versorgen.

Es ist bekannt, einen Versorgungs-Kondensator eines Taktgebers mit integrierter Treiberschaltung (PWM-Controller) über einen hochohmigen Widerstand aus der Eingangsspannung eines als Sperrwandler ausgebildeten Stromrichters zu laden und die Kondensatorspannung über eine parallele Z-Diode zu begrenzen. Der Wirkungsgrad dieser Anordnung ist gering, da bei einer Eingangsspannung von beispielsweise 400V und einer benötigten Treiberspannung von 15V nur ein Wirkungsgrad von 15V/400V= 3,8% erzielt wird. Damit eignet sich diese bekannte Anordnung nur für den Anlauffall des Sperrwandlers.

Die Druckschrift DE 10 2008 047 028 B4 offenbart eine Schaltungsanordnung mit einem Leistungshalbleiterschalter und einer Treiberschaltung zur Ansteuerung des Leistungshalbleiterschalters, wobei ein Bezuqspotentialanschluss des Leistungshalbleiterschalters ein gleitendes Potential aufweist und über eine Diode mit einer Schirmfläche verbunden ist, welche in Verbindung mit einer der Schirmfläche gegenüberliegenden Metallisierungslage, die auf einem konstanten Bezugspotential liegt, eine Kapazität ausbildet, welche funktional mit der Diode in Reihe geschaltet ist. Die Schirmfläche ist weiterhin über eine Bootstrapdiode mit einem ersten Anschluss eines Versorgungskondensators verbunden, dessen zweiter Anschluss mit dem Bezugspotentialanschluss des Leistungshalbleiterschalters verbunden ist. An den Anschlüssen des Versorgungskondensators wird die Versorgungsspannung für die Treiberschaltung abgegriffen. Der Versorgungskondensator wird über die Bootstrapdiode von dem Hilfskondensator geladen.

Der Erfindung liegt die Aufgabe zugrunde, eine leistungselektronische Vorrichtung der eingangs genannten Art, insbesondere einen Stromrichter der eingangs genannten Art, und ein Verfahren der eingangs genannten Art anzugeben, mit welchen eine elektrische Spannungsversorgung mindestens einer Treiberschaltung eines Leistungshalbleiterschalters in einer Art und Weise ermöglicht wird, die sich mindestens für einen Betriebsmodus der leistungselektronischen Vorrichtung bzw. des Leistungshalbleiterschalters eignet.

Die Aufgabe wird erfindungsgemäß bei einer leistungselektronischen Vorrichtung der eingangs genannten Art dadurch gelöst, dass eine elektrische Hilfs-Schaltungsanordnung zur elektrischen Spannungsversorgung der Treiberschaltung umfasst ist, wobei die Hilfs-Schaltungsanordnung einen Versorgungs- und einen Hilfskondensator, einen selbstsperrenden Hilfshalbleiterschalter, eine Diode und eine Bootstrapdiode umfasst. Hierbei ist der Hilfshalbleiterschalter über einen ersten Anschlusspunkt an einem Bezugspotentialanschluss des ersten Leistungshalbleiterschalters angeschlossen. Ausgehend von dem ersten Anschlusspunkt ist eine Reihenschaltung der Diode, eines zweiten Anschlusspunktes und des Hilfskondensators parallel zum Hilfshalbleiterschalter angeordnet, so dass bei gesperrtem Hilfshalbleiterschalter durch Stromfluss über den Leistungshalbleiterschalter der Hilfskondensator geladen wird. Die Treiberschaltung ist zu ihrer elektrischen Spannungsversorgung an den Versorgungskondensator angeschlossen und der Versorgungskondensator ist mit einem ersten Anschluss über die Bootstrapdiode mit dem zweiten Anschlusspunkt und mit einem zweiten Anschluss mit dem Bezugspotentialanschluss elektrisch verbunden, so dass bei leitendem Hilfshalbleiterschalter und mindestens teilweise geladenem Hilfskondensator der Versorgungskondensator über die Bootstrapdiode von dem Hilfskondensator geladen wird.

Die erfindungsgemäße Aufgabe wird somit bei einer leistungselektronischen Vorrichtung der eingangs genannten Art mit einer Hilfsschaltung gelöst, die einen Hilfsschalter umfasst, der in eine Grundschaltung für eine Hauptfunktion der leistungselektronischen Vorrichtung integriert ist. Beispielsweise ist eine Hauptfunktion eines Stromrichters das Richten von Strom. Der Hilfsschalter dient dabei nur der elektrischen Versorgung der Treiberschaltung des ersten Leistungshalbleiterschalters und gegebenenfalls weiterer Treiberschaltungen von weiteren Leistungshalbleiterschaltern und hat keinen oder im Wesentlichen keinen Einfluss auf die Hauptfunktion der leistungselektronischen Vorrichtung bzw. des Stromrichters, im Gegensatz zu dem der Hauptfunktion dienenden ersten Leistungshalbleiterschalter. Die Zeitspannen, in denen der Hilfsschalter zum Laden des Versorgungskondensators vom Hilfskondensator geschlossen - also leitend - ist, stören diese Hauptfunktion der leistungselektronischen Vorrichtung bzw. des Stromrichters ohnehin nicht, da der leitende Hilfsschalter sich im Wesentlichen wie ein Abschnitt einer elektrischen Verbindung verhält. Im Anlauffall der leistungselektronischen Vorrichtung bzw. des Stromrichters - also während eines Aufstart-Prozesses der ausgeschalteten leistungselektronischen Vorrichtung bzw. des Stromrichters, liegt am ersten Leistungshalbleiterschalter zwischen Bezugspotentialanschluss und weiterem Hauptanschluss des ersten Leistungshalbleiterschalters eine DC-Spannung an, beispielsweise weil an einem Eingang der leistungselektronischen Vorrichtung eine DC-Spannung von einem DC-Generator anliegt. Im Anlauffall kann der Hilfsschalter eine Hauptfunktion der leistungselektronischen Vorrichtung bzw. des Stromrichters per se nicht stören, da diese während des Anlauffalls noch nicht vorhanden ist. Während des Betriebs der leistungselektronischen Vorrichtung bzw. des Stromrichters wird der erste Leistungshalbleiterschalter mit hohen Frequenzen geschaltet. Ist der erste Leistungshalbleiterschalter sperrend - also nicht leitend - dann verhält sich der Hilfsschalter je nach seinem Schaltzustand entweder wie ein Abschnitt einer elektrischen Verbindung oder wie der erste Leistungshalbleiterschalter selber, so dass eine Hauptfunktion der leistungselektronischen Vorrichtung bzw. des Stromrichters unabhängig vom jeweiligen Schaltzustand des Hilfsschalters nicht beeinflusst wird. Ist der erste Leistungshalbleiterschalter geschlossen - also leitend - dann fließt über den ersten Leistungshalbleiterschalter die Stromstärke des Leistungspfades der Grundschaltung, die aufgrund des hierzu geringen Energiebedarfs für die Treiberschaltung durch das Aufladen des Hilfskondensators nicht wesentlich beeinflusst wird und aufgrund ihrer Stromstärke die Zeitspannen, in denen der Hilfsschalter gesperrt ist, so gering hält, dass keine wesentliche Beeinflussung der Hauptfunktion erfolgt.

Im Anlauffall kann der Hilfskondensator über den ersten Leistungshalbleiterschalter und die erste Diode geladen werden, wobei der erste Leistungshalbleiterschalter selbstleitend sein kann oder selbstsperrend. In beiden Fällen kann der erste Leistungshalbleiterschalter im gesperrten Schaltzustand einen Leckstrom aufweisen. Üblicherweise ist der erste Leistungshalbleiterschalter selbstsperrend und weist im gesperrten Schaltzustand bei einer anliegenden elektrischen Spannung zwischen den beiden Hauptanschlüssen des Leistungshalbleiterschalters, also dem Bezugspotentialanschluss und dem weiteren Hauptanschluss des Leistungshalbleiterschalters, einen Leckstrom auf. Ein Leckstrom ist ein Reststrom, der bei einem ausgeschalteten Leistungshalbleiterschalter noch durch das Bauteil fließt, sofern eine entsprechende Spannung anliegt. Dieser fließt in der regulären Durchflussrichtung durch den Leistungshalbleiterschalter oder in Sperrrichtung über eine Bodydiode des Leistungshalbleiterschalters bzw. eine von dem Leistungshalbleiterschalter umfasste ergänzende Diode mit gleicher Polung wie eine Bodydiode. Im Betrieb der leistungselektronischen Vorrichtung bzw. des Stromrichters kann der Hilfskondensator während den Zeitspannen mit gesperrtem ersten Leistungshalbleiterschalter ebenfalls über einen Leckstrom des ersten Leistungshalbleiterschalters geladen werden und während den Zeitspannen im Betrieb mit leitendem ersten Leistungshalbleiterschalter mittels eines Anteils des den ersten Leistungshalbleiterschalter regulär durchfließenden Stroms. Bei jedem Einschalten des Hilfshalbleiterschalters gibt der Hilfskondensator mindestens einen Teil seiner Ladung an den Versorgungskondensator ab, so dass aus diesem die eigentliche Treiberschaltung versorgt werden kann. Um eine Ladezeit des Versorgungskondensators im Anlauffall zu verkürzen, kann ein Anlaufwiderstand ergänzend angeordnet sein, so dass ein zusätzlicher Ladestrom für den Versorgungskondensator und den Hilfskondensator bereitgestellt wird. Ein Anschluss des Anlaufwiderstandes kann beispielsweise mit dem weiteren Hauptanschluss des ersten Leistungshalbleiterschalters elektrisch verbunden sein und ein zweiter Anschluss des Anlaufwiderstandes mit dem ersten Anschluss des Versorgungskondensators der Treiberschaltung elektrisch verbunden sein.

Erfindungsgemäß erfolgt somit die elektrische Spannungsversorgung der Treiberschaltung des ersten Leistungshalbleiterschalters durch Laden des Versorgungskondensators aus dem Hilfskondensator, wobei der Hilfskondensator im Betrieb der leistungselektronischen Vorrichtung bzw. des Stromrichters mittels des ohnehin über den ersten Leistungshalbleiterschalter fließenden Stroms (Leckstrom oder Strom bei durchgeschaltetem ersten Leistungshalbleiterschalter) aufgeladen wird, so dass mit der erfindungsgemäßen leistungselektronischen Vorrichtung bzw. mit dem erfindungsgemäßen Stromrichter eine Spannungsversorgung der Treiberschaltung des ersten Leistungshalbleiterschalters ermöglicht ist, welche sich aufgrund ihres guten Wirkungsgrades sowohl für den Anlauffall als auch für den Betrieb der leistungselektronischen Vorrichtung bzw. des Stromrichters eignet.

Zur Verdeutlichung der Integration des Hilfsschalters der Hilfs-Schaltungsanordnung in eine den ersten Leistungshalbleiterschalter umfassenden Grundschaltung für eine Hauptfunktion eines Stromrichters, kann der Stromrichter gemäß einem Ausführungsbeispiel einen Eingang und einen Ausgang aufweisen, wobei ein dritter Anschlusspunkt mit einem ersten Anschluss des Eingang elektrisch verbunden ist und ein vierter Anschlusspunkt mit einem zweiten Anschluss des Eingangs verbunden ist, wobei sich ein erster Verbindungszweig vom dritten zum vierten Anschlusspunkt erstreckt. Ausgehend vom dritten Anschlusspunkt umfasst gemäß dem Ausführungsbeispiel der erste Verbindungszweig den ersten Leistungshalbleiterschalter, den ersten Anschlusspunkt und den selbstsperrenden Hilfsschalter in Reihe. Ein zweiter elektrischer Verbindungszweig erstreckt sich gemäß dem Ausführungsbeispiel vom vierten bis zu einem fünften Anschlusspunkt und umfasst ausgehend vom vierten Anschlusspunkt den Hilfskondensator, den zweiten Anschlusspunkt, die Diode, den ersten Anschlusspunkt und den Versorgungskondensator in Reihe, wobei der fünfte und zweite Anschlusspunkt parallel zum zweiten Verbindungszweig über die Bootstrapdiode elektrisch verbunden sind. Der Stromrichter umfasst zudem gemäß dem Ausführungsbeispiel eine mit einem Treiberausgang mit dem Steueranschluss des ersten Leistungshalbleiterschalters elektrisch verbundene Treiberschaltung, welche zu ihrer Spannungsversorgung parallel zum Versorgungskondensator geschaltet ist. Der Stromrichter kann gemäß dem Ausführungsbeispiel auch eine mit einem Komparator-Ausgang mit dem Steueranschluss des Hilfsschalters verbundene Komparator-Schaltung umfassen, welche dazu ausgebildet ist, in Abhängigkeit einer Ladespannung des Hilfskondensators an ihrem Komparator-Ausgang ein Steuersignal bereit zu stellen, wobei eine Durchlassrichtung der Diode derart angeordnet ist, dass in mindestens einem ersten Betriebszustand des Stromrichters der Hilfskondensator bei gesperrtem Hilfsschalter über die Diode und den ersten Leistungshalbleiterschalter geladen wird, und eine Durchlassrichtung der Bootstrapdiode derart angeordnet ist, dass in mindestens einem zweiten Betriebszustand bei durchgeschaltetem Hilfsschalter der Versorgungskondensator über die Bootstrapdiode vom Hilfskondensator geladen wird.

Vorteilhafte Ausgestaltungen der Erfindung sind in der nachfolgenden Beschreibung und den Unteransprüchen angegeben, deren Merkmale einzeln und in beliebiger Kombination miteinander angewendet werden können.

Es kann vorteilhaft vorgesehen sein, dass die Hilfs-Schaltungsanordnung eine Ansteuerschaltung umfasst, welche dazu ausgebildet und eingerichtet ist, in Abhängigkeit einer Ladespannung des Hilfskondensators ein Steuersignal zum Schalten des Hilfshalbleiterschalters an einem Steuer-Eingang des Hilfshalbleiterschalters bereit zu stellen.

Die Ansteuerschaltung kann ihre eigene Spannungsversorgung aus dem Hilfskondensator beziehen, da der Hilfsschalter selbstsperrend ist und sich der Hilfskondensator somit zunächst über den ersten Leistungshalbleiterschalter aufladen kann und erst zum Laden des Versorgungskondensators aus dem Hilfskondensator ein Steuersignal von der Ansteuerschaltung am Steuereingang des Hilfsschalters bereitgestellt werden muss. Der Hilfsschalter kann dann geschlossen werden, wenn der Hilfskondensator auf eine Spannung aufgeladen ist, die zur Versorgung der Treiberschaltung ausreichend ist und kann bei einer kleineren Ladespannung wieder geöffnet (Hysterese) werden, so dass der Hilfskondensator nach dem Bootstrapprinzip über die Bootstrapdiode den Versorgungskondensator für die Treiberschaltung des ersten Leistungshalbleiterschalters jedes Mal versorgt, wenn der Hilfsschalter durchgeschaltet ist. Die Hilfs-Schaltungsanordnung kann derart ausgebildet sein, dass nach dem ersten Durchschalten des ersten Leistungshalbleiterschalters der Versorgungskondensator aufgeladen ist und die Treiberschaltung versorgt, sodass mit dem Takten des ersten Leistungshalbleiterschalters höhere Ströme durch die Hilfsschaltung fließen und der Hilfskondensator und der Versorgungskondensator ständig nachgeladen werden. Die Ansteuerschaltung kann insbesondere derart ausgebildet und eingerichtet sein, dass bei einem Überschreiten eines ersten Schwellwerts durch die Ladespannung des Hilfskondensators die Ansteuerschaltung ein den Hilfsschalter durchschaltendes Steuersignal an seinem Steuer-Eingang bereitstellt. Der erste Schwellwert kann einer Versorgungsspannung der Treiberschaltung entsprechen oder im Wesentlichen entsprechen. Unter dem Begriff "Versorgungsspannung der Treiberschaltung" sei im Rahmen dieser Anmeldung nicht eine an der Treiberschaltung anliegende bzw. die von dem Versorgungskondensator für die Treiberschaltung bereitgestellte Spannung gemeint, sondern ein von der Treiberschaltung bauteilbedingt zum Ansteuern des ersten Leistungshalbleiterschalters geeigneter Spannungswert gemeint. Eine Versorgungsspannung der Treiberschaltung kann beispielsweise zwischen einer bauteilbedingten minimalen Versorgungsspannung und einer bauteilbedingten maximalen Versorgungsspannung der Treiberschaltung liegen oder ein bauteilbedingt vorgegebener Spannungswert sein, und insbesondere ein in Abhängigkeit des ersten Leistungshalbleiterschalters geeignet ausgewählter Spannungswert zur Versorgung der Treiberschaltung sein. Da der Hilfsschalter und die Hilfs-Schaltungsanordnung beim Erreichen des ersten Schwellwertes mittels Durchschaltens des Hilfsschalters vor zu hoher Spannung geschützt sind, können alle Bauteile der Hilfs-Schaltungsanordnung nur auf diese geringere Spannung ausgelegt sein, so dass für die Hilfs-Schaltungsanordnung preiswerte Bauteile verwendet werden können.

Es kann auch als vorteilhaft angesehen werden, dass die Ansteuerschaltung dazu ausgebildet und eingerichtet ist, bei einer einen ersten Schwellwert überschreitenden Ladespannung des Hilfskondensators ein den Hilfshalbleiterschalter durchschaltendes Steuersignal am Steuer-Eingang des Hilfshalbleiterschalters bereitzustellen, und bei einer einen zweiten Schwellwert unterschreitenden Ladespannung des Hilfskondensators, der geringer ist als der erste Schwellwert, ein den Hilfshalbleiterschalter sperrendes Steuersignal am Steuer-Eingang des Hilfshalbleiterschalters bereitzustellen, wobei der erste Schwellwert mindestens einer Versorgungsspannung der Treiberschaltung entspricht.

Da es sich bei dem Hilfsschalter um einen selbstsperrenden Hilfsschalter handelt, kann ein sperrendes Steuersignal beispielsweise auch ein nicht vorhandenes Steuersignal sein. Dieses sei im Rahmen der Erfindung auch mit "sperrendem Steuersignal" bezeichnet. Mit anderen Worten kann die Ansteuerschaltung bei einer einen zweiten Schwellwert unterschreitenden Ladespannung des Hilfskondensators auch am Steuer-Eingang des Hilfshalbleiterschalters kein Steuersignal bereitstellen, da dieses - je nach Schaltertyp - auf den Hilfshalbleiterschalter ebenfalls sperrend wirken kann. Mit dem Begriff "durchschaltendes" ist ein Steuersignal bezeichnet, dass den Hilfshalbleiterschalter in einem geschlossenen Schalter-Zustand, also in einem leitenden Schalter-Zustand, versetzt, so dass der Versorgungskondensator vom Hilfskondensator geladen wird.

Der erste Schwellwert kann mindestens dem Spannungswert einer Versorgungsspannung der Treiberschaltung des ersten Leistungshalbleiterschalters entsprechen. Bezüglich der Bedeutung des Begriffs "Versorgungsspannung der Treiberschaltung" sei auf die obigen Ausführungen verwiesen. Insbesondere kann der erste Schwellwert gleich oder etwas höher (beispielsweise um eine Durchlassspannung der Bootstrapdiode höher) als diese Versorgungsspannung sein derart, dass im Betrieb bei der Aufladung des Versorgungskondensators durch den Hilfskondensator sich an ersterem im Wesentlichen die Versorgungsspannung für die Treiberschaltung einstellt. Die vorteilhafte Ausgestaltung der Ansteuerschaltung der leistungselektronischen Vorrichtung weist eine Hysterese-Funktion auf, die eine Instabilität des Schaltverhaltens des Hilfsschalters bei der Aufladung des Versorgungskondensators durch den Hilfskondensator vermeidet.

Gemäß einer vorteilhaften Ausgestaltung der Erfindung kann die Ansteuerschaltung ein Zweipunktregler, insbesondere eine Komparator-Schaltung, oder ein Monoflop oder eine PWM-Regelung oder eine Frequenzregelung sein.

Die vorteilhafte Ausgestaltung der Erfindung kann mit Standard-Bauteilen realisiert werden. Beispielsweise kann die Komparator-Schaltung einen üblichen Komparator mit einem invertierenden und einem nichtinvertierenden Eingang und einem Ausgang - der mit dem Steuer-Eingang des Hilfsschalters verbunden wird - umfassen. Für ein Hysterese-Verhalten ist ein Mitkopplungswiderstand elektrisch zwischen dem Ausgang des Komparators und dem nichtinvertierenden Eingang umfasst.

Vorteilhafterweise kann weiter vorgesehen sein, dass die Ansteuerschaltung derart ausgebildet und eingerichtet und mit dem Hilfskondensator elektrisch verbunden ist, dass die elektrische Spannungsversorgung der Ansteuerschaltung mittels des Hilfskondensators erfolgt.

Die elektrische Versorgung der Ansteuerschaltung durch den Hilfskondensator ist besonders effizient. Beispielsweise kann die Ansteuerschaltung parallel zum Hilfskondensator geschaltet sein. Im Falle der Ausbildung als Komparator-Schaltung kann diese einen Komparator umfassen, der mit zwei Versorgungsanschlüssen parallel zum Hilfskondensator geschaltet ist. Am nichtinvertierenden Eingang des Komparators kann über eine Beschaltung die Ladespannung des Hilfskondensators und am invertierenden Eingang des Komparators eine Referenzspannung anliegen. Beispielsweise indem parallel zum Hilfskondensator eine Reihenschaltung aus einer Z-Diode in Sperrrichtung, einem achten Anschlusspunkt und einem Widerstand angeordnet ist, wobei der nichtinvertierende Eingang des Komparators am achten Anschlusspunkt und der invertierende Eingang des Komparators an einem Referenzpotential angeschlossen sind.

Es kann auch als vorteilhaft angesehen werden, dass der Hilfshalbleiterschalter die gleiche Polarität aufweist, wie der erste Leistungshalbleiterschalter.

Vorteilhafterweise kann weiter vorgesehen sein, dass der erste Leistungshalbleiterschalter selbstsperrend ausgebildet ist und im gesperrten Schaltzustand bei einer anliegenden elektrischen Spannung zwischen dem Bezugspotentialanschluss und einem weiteren Hauptanschluss des ersten Leistungshalbleiterschalters einen Leckstrom aufweist.

Der erste Leistungshalbleiterschalter weist einen Bezugspotentialanschluss, einen weiteren Hauptanschluss und einen Steueranschluss auf. Als Ausführungsbeispiel für einen selbstsperrenden ersten Leistungshalbleiterschalter kann der erste Leistungshalbleiterschalter in Form eines n-Kanal-MOSFETs ausgebildet sein und der Bezugspotentialanschluss kann der Source-Anschluss des MOSFETs sein und der weitere Hauptanschluss der Drain-Anschluss des MOSFETs.

Alternativ zu der genannten vorteilhaften Ausgestaltung der Erfindung kann der erste Leistungshalbleiterschalter selbstsperrend ausgebildet sein und ein Anlaufwiderstand umfasst sein. Der Anlaufwiderstand kann mit einem ersten Anschluss mit dem weiteren Hauptanschluss des ersten Leistungshalbleiterschalters verbunden sein und mit einem zweiten Anschluss mit einem Anschluss des Versorgungskondensators verbunden sein.

Sofern der selbstsperrende erste Leistungshalbleiterschalter einen Leckstrom aufweist, kann der Anlaufwiderstand eine Anlaufzeit vorteilhaft verkürzen. Sofern der selbstsperrende erste Leistungshalbleiterschalter keinen Leckstrom aufweist, ermöglicht der Anlaufwiderstand im Anlauffall eine Aufladung des Versorgungskondensators und des Hilfskondensators, so dass bei gesperrtem Hilfshalbleiterschalter im Anlauffall durch Stromfluss über den Anlaufwiderstand und nachfolgend im Betrieb durch Stromfluss über den ersten Leistungshalbleiterschalter der Hilfskondensator geladen wird.

Weiter kann vorteilhaft vorgesehen sein, dass die Hilfs-Schaltungsanordnung, insbesondere der Hilfshalbleiterschalter, ausschließlich der Versorgung mindestens einer Treiberschaltung dient.

Diese Ausgestaltung der Erfindung dient der Klarstellung, dass der Hilfsschalter keinen oder im Wesentlichen keinen Einfluss auf die Hauptfunktion der leistungselektronischen Vorrichtung bzw. des Stromrichters hat, so wie der der Hauptfunktion dienende erste Leistungshalbleiterschalter. Der Hilfsschalter ist zwar in eine Grundschaltung für die Hauptfunktion der leistungselektronischen Vorrichtung integriert, ist aber somit nicht von den Leistungshalbleiterschaltern der leistungselektronischen Vorrichtung bzw. des Stromrichters umfasst, die im Falle des Stromrichters dazu angeordnet und eingerichtet sind, die den Strom richtenden Hauptfunktion des Stromrichters zu realisieren.

Eine vorteilhafte Ausgestaltung der Erfindung kann vorsehen, dass die Treiberschaltung mit einem Taktgeber integriert ausgebildet ist, wobei der Taktgeber zur Generierung eines Pulsmusters des durch die Treiberschaltung bereitgestellten Steuersignals ausgebildet ist.

Dies reduziert einen Platzbedarf für die Bauteile sowie die Herstellungskosten der leistungselektronischen Vorrichtung.

Alternativ kann das Pulsmuster in einem anderen Schaltungsteil erzeugt und der Treiberschaltung direkt oder potentialgetrennt (zum Beispiel über einen Optokoppler) zugeführt werden.

Es kann auch als vorteilhaft angesehen werden, dass die leistungselektronische Vorrichtung eine Halbbrücke umfasst, welche ausgehend von einem dritten Anschlusspunkt eine Reihenschaltung aus einem High-Side-Leistungshalbleiterschalter, einen Abzweigpunkt und einen Low-Side-Leistungshalbleiterschalter und einen vierten Anschlusspunkt umfasst, wobei der Low-Side-Leistungshalbleiterschalter als erster Leistungshalbleiterschalter ausgebildet ist, wobei insbesondere die leistungselektronische Vorrichtung ein DC/DC-Steller oder ein Wechselrichters ist.

Der Hilfsschalter ist gemeinsam mit dem ersten Leistungshalbleiterschalter oberhalb oder unterhalb des Abzweigpunktes angeordnet. Gemäß der erfindungsgemäßen Ausgestaltung ist mindestens eine Hilfs-Schaltungsanordnung zur elektrischen Spannungsversorgung der Treiberschaltung zur Ansteuerung des Low-Side-Leistungshalbleiterschalters von der leistungselektronischen Vorrichtung umfasst. Dies ermöglicht die elektrische Spannungsversorgung der Treiberschaltung des Low-Side-Leistungshalbleiterschalters im Anlauffall und im Betrieb. Die leistungselektronische Vorrichtung kann einen Anlaufwiderstand umfassen, der mit einem Anschluss mit dem dritten Anschlusspunkt oder dem Abzweigpunkt verbunden ist und mit einem weiteren Anschluss mit dem ersten Anschluss des Versorgungskondensators der Hilfs-Schaltungsanordnung zur elektrischen Spannungsversorgung der Treiberschaltung zur Ansteuerung des Low-Side-Leistungshalbleiterschalters verbunden ist.

Sofern der Stromrichter ein Wechselrichter ist, kann dieser beispielsweise ein einphasiger Wechselrichter sein und eine Vollbrücke (sogenannte H-Brücke) aus zwei Halbbrücken umfassen, wobei einem oder beiden Abzweigpunkten eine Drossel nachgeschaltet ist. Der Wechselrichter kann beispielsweise auch ein dreiphasiger Wechselrichter sein und je Phase eine Halbbrücke umfassen, wobei den drei Abzweigpunkten je eine Drossel nachgeschaltet ist. Sofern der Stromrichter ein bidirektionaler DC/DC-Steller ist, kann dieser eine Halbbrücke umfassen, deren Abzweigpunkt eine Drossel nachgeschaltet ist. Mit einer Halbbrücke kann eine Spannung unabhängig von der Stromrichtung gestellt werden. Es kann somit Energie in beide Richtungen übertragen werden. Der Begriff des Eingangs und Ausgangs des Stromrichters ist somit gegebenenfalls willkürlich gewählt. Bezüglich eines Wechselrichters sei der Eingang DC-seitig und der Ausgang AC-seitig angeordnet und bezeichnet. Zur elektrischen Spannungsversorgung der Treiberschaltungen der Low-Side-Leistungshalbleiterschalter des Wechselrichters kann für jeden Low-Side-Leistungshalbleiterschalter jeweils eine eigene Hilfs-Schaltungsanordnung und ein eigener Hilfsschalter gemäß der erfindungsgemäßen Ausgestaltung umfasst sein.

Es kann auch als vorteilhaft angesehen werden, dass ein Zwischenkreis umfasst ist mit einer den dritten Anschlusspunkt mit dem vierten Anschlusspunkt über einen oder mehrere in Reihe oder parallel geschaltete Zwischenkreiskondensatoren verbindenden elektrischen Verbindung.

Weiter kann vorteilhaft vorgesehen sein, dass sowohl für den High-Side-Leistungshalbleiterschalter als auch den Low-Side-Leistungshalbleiterschalter jeweils eine Treiberschaltung zur Ansteuerung des jeweiligen Leistungshalbleiterschalters und jeweils eine eigene elektrische Hilfs-Schaltungsanordnung zur elektrischen Spannungsversorgung der Treiberschaltung umfasst ist, so dass sowohl der High-Side- als auch der Low-Side-Leistungshalbleiterschalter jeweils als ein erster Leistungshalbleiterschalter ausgebildet sind.

Alternativ kann vorteilhaft vorgesehen sein, dass zur Ansteuerung des High-Side-Leistungshalbleiterschalters eine Treiberschaltung und zur elektrischen Spannungsversorgung dieser Treiberschaltung ein Versorgungskondensator umfasst ist, der mit einem Anschluss mit einem Bezugspotentialanschluss des High-Side-Leistungshalbleiterschalter elektrisch verbunden ist und mit einem weiteren Anschluss über eine weitere Bootstrapdiode mit dem ersten Anschluss des von der Hilfs-Schaltungsanordnung umfassten Versorgungskondensators zur elektrischen Spannungsversorgung der Treiberschaltung zur Ansteuerung des Low-Side-Leistungshalbleiterschalters elektrisch verbunden ist.

Es kann auch vorteilhaft vorgesehen sein, dass der High-Side- und der Low-Side-Leistungshalbleiterschalter selbstsperrend sind und in gesperrtem Schaltzustand bei anliegender elektrischer Spannung zwischen ihrem Bezugspotentialanschluss und ihrem weiteren Hauptanschluss einen Leckstrom aufweisen.

Eine weitere Aufgabe der Erfindung ist es, ein Verfahren zur elektrischen Spannungsversorgung einer Treiberschaltung anzugeben, mit welchem eine elektrische Spannungsversorgung mindestens einer Treiberschaltung eines Leistungshalbleiterschalters in einer Art und Weise ermöglicht wird, die sich mindestens für einen Betriebsmodus des Leistungshalbleiterschalters eignet.

Hierzu wird die Treiberschaltung von einem Versorgungskondensator mit Spannung versorgt, wobei zur Aufladung des Versorgungskondensators ein Hilfskondensator mittels eines über den Leistungshalbleiterschalter fließenden Stroms aufgeladen wird während eines gesperrten Schaltzustandes eines selbstsperrenden Hilfsschalters. Der Versorgungskondensator wird vom Hilfskondensator aufgeladen, wenn der selbstsperrende Hilfsschalter durchgeschaltet ist.

Der Hilfskondensator kann somit über einen oder einen Teil eines über den Leistungshalbleiterschalter ohnehin fließenden Stroms aufgeladen werden, so dass diese Aufladung des Hilfskondensators besonders energieeffizient ist. Die im Hilfskondensator derart gespeicherte elektrische Energie kann mindestens teilweise zur Versorgung des Versorgungskondensators und damit letztendlich zur Ansteuerung des Leistungshalbleiterschalters verwendet werden und kann beispielsweise auch zum Ansteuern des Hilfsschalters verwendet werden oder zur Versorgung mindestens eines weiteren Versorgungskondensators mindestens einer weiteren Treiberschaltung. Bei dem über den Leistungshalbleiterschalter fließenden Stroms kann es sich beispielsweise um einen Leckstrom im Anlauffall oder um einen Arbeitsstrom im Betrieb des Leistungshalbleiterschalters handeln, so dass sich das Verfahren sowohl für den Anlauffall als auch für den Betrieb des Leistungshalbleiterschalters eignet. Der Leistungshalbleiterschalter kann auch mit erstem Leistungshalbleiterschalter bezeichnet werden. Das Verfahren kann mit einer Vorrichtung nach einem der Ansprüche 1 bis 14 durchgeführt werden, wobei der in dem Verfahren verwendete Leistungshalbleiterschalter ein erster Leistungshalbleiterschalter der Vorrichtung ist.

Es kann auch als vorteilhaft angesehen werden, dass der selbstsperrende Hilfsschalter an einen Bezugspotentialanschluss des Leistungshalbleiters angeschlossen ist, so dass in einem ersten Schritt bei gesperrtem Hilfsschalter mindestens ein Teil des über den Leistungshalbleiterschalter fließenden Stroms auf den Hilfskondensator umgeleitet wird und diesen mindestens teilweise auflädt, wobei in einem zweiten Schritt der Hilfsschalter durchgeschaltet wird und mindestens einen Teil der Ladung des Hilfskondensators an den Versorgungskondensator abgibt, und in einem dritten Schritt der Hilfsschalter wieder in einen gesperrten Schaltzustand überführt wird, so dass durch mehrfaches Wiederholen der drei Schritte dem Versorgungskondensator eine elektrische Leistung zugeführt wird, um die Treiberschaltung im Betrieb zu versorgen.

Vorteilhafterweise kann auch vorgesehen sein, dass der Hilfsschalter in Abhängigkeit einer Ladespannung des Hilfskondensators durchgeschaltet wird.

Diese Vorgehensweise ist unabhängig von einer aktuellen Stärke des Stromes, der über den Leistungshalbleiterschalter fließt und eignet sich somit sowohl für einen Anlauffall als auch für einen Betrieb des Leistungshalbleiterschalters.

Vorteilhafterweise kann auch vorgesehen sein, dass der Hilfsschalter durchgeschaltet wird, wenn eine Ladespannung des Hilfskondensator einen ersten Schwellwert überschreitet und der Hilfsschalter gesperrt wird, wenn die Ladespannung des Hilfskondensator einen zweiten Schwellwert unterschreitet, wobei der zweite Schwellwert geringer ist als der erste Schwellwert.

Die vorteilhafte Ausgestaltung des Verfahrens ermöglicht eine Aufladung des Versorgungskondensators durch den Hilfskondensator bei gleichzeitig stabilem Schaltverhalten des Hilfsschalters. Der erste Schwellwert kann mindestens dem Spannungswert einer Versorgungsspannung der Treiberschaltung des Leistungshalbleiterschalters entsprechen. Insbesondere kann der erste Schwellwert gleich oder etwas höher als der Spannungswert der Versorgungsspannung sein derart, dass im Betrieb bei der Aufladung des Versorgungskondensators durch den Hilfskondensator sich an ersterem im Wesentlichen die Versorgungsspannung für die Treiberschaltung einstellt. Unter dem Begriff "Versorgungsspannung der Treiberschaltung" sei im Rahmen dieser Anmeldung nicht eine an der Treiberschaltung anliegende bzw. die von dem Versorgungskondensator für die Treiberschaltung bereitgestellte Spannung gemeint, sondern ein von der Treiberschaltung bauteilbedingt zum Ansteuern des Leistungshalbleiterschalters geeigneter Spannungswert gemeint. Eine Versorgungsspannung der Treiberschaltung kann beispielsweise zwischen einer bauteilbedingten minimalen Versorgungsspannung und einer bauteilbedingten maximalen Versorgungsspannung der Treiberschaltung liegen oder ein bauteilbedingt vorgegebener Spannungswert sein, und insbesondere ein in Abhängigkeit des Leistungshalbleiterschalters geeignet ausgewählter Spannungswert zur Versorgung der Treiberschaltung sein.

Es kann auch als vorteilhaft angesehen werden, dass das Verfahren mit einer leistungselektronischen Vorrichtung nach einem der Ansprüche 1 bis 14 durchgeführt wird.

Dies ermöglicht die elektrische Spannungsversorgung mindestens der Treiberschaltung des ersten Leistungshalbleiterschalters auf energieeffiziente Art und Weise sowohl im Anlauffall als auch im Betrieb der Vorrichtung.

Weitere zweckmäßige Ausgestaltungen und Vorteile der Erfindung sind Gegenstand der Beschreibung von Ausführungsbeispielen der Erfindung unter Bezug auf die Figuren der Zeichnung, wobei gleiche Bezugszeichen auf gleich wirkende Bauteile verweisen.

Dabei zeigt die
Fig. 1 schematisch einen Hochsetzstellers nach dem Stand der Technik,
Fig. 2 schematisch einen Tiefsetzstellers nach dem Stand der Technik,
Fig. 3 schematisch eine Halbbrückenanordnung nach dem Stand der Technik,
Fig. 4 schematisch einen Wechselrichters nach dem Stand der Technik,
Fig. 5 schematisch einen Hochsetzsteller gemäß einem ersten Ausführungsbeispiel der Erfindung,
Fig. 6 schematisch eine Halbbrückenanordnung gemäß einem zweiten Ausführungsbeispiel der Erfindung,
Fig. 7 schematisch eine Halbbrückenanordnung gemäß einem dritten Ausführungsbeispiel der Erfindung, und
Fig. 8 ein Ablaufdiagram eines Verfahrens gemäß einem vierten Ausführungsbeispiel der Erfindung.

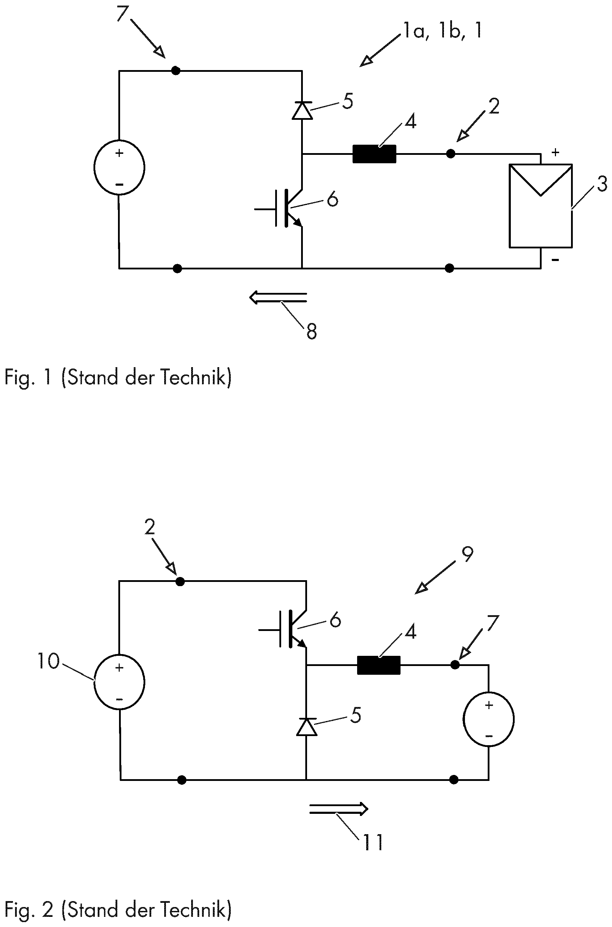

Die Figur 1 offenbart eine leistungselektronische Vorrichtung 1a, die ein Stromrichter 1b ist in Form eines Hochsetzstellers 1 in schematischer Darstellung gemäß dem Stand der Technik, wobei zur Übersichtlichkeit der Darstellung Details wie beispielsweise ein Gehäuse des Hochsetzstellers 1 nicht dargestellt sind. An einem Eingang 2 des Hochsetzstellers 1 ist ein Gleichspannungsgenerator 3 angeschlossen, der eine Gleichspannung bereitstellt. Der Hochsetzsteller 1 umfasst eine Drossel 4, eine Diode 5 und einen Leistungshalbleiterschalter 6. Zur Umwandlung der am Eingang 2 anliegenden Gleichspannung in eine höhere, am Ausgang 7 bereitzustellende Gleichspannung wird der Leistungshalbleiterschalter 6 von einer Treiberschaltung (nicht dargestellt) angesteuert und entsprechend geschaltet, so dass ein elektrischer Energiefluss in Richtung des Pfeils 8 entsteht.

Die Figur 2 offenbart einen Stromrichter in Form eines Tiefsetzstellers 9 in schematischer Darstellung gemäß dem Stand der Technik. An einem Eingang 2 des Tiefsetzstellers ist eine Gleichspannungsquelle 10 angeschlossen. Der Tiefsetzsteller 9 umfasst einen Leistungshalbleiterschalter 6, eine Diode 5 und eine Drossel 4. Zur Umwandlung der am Eingang 2 anliegenden Gleichspannung in eine geringere, am Ausgang 7 bereitzustellende Gleichspannung wird der Leistungshalbleiterschalter 6 von einer Treiberschaltung (nicht dargestellt) angesteuert und entsprechend geschaltet, so dass ein elektrischer Energiefluss in Richtung des Pfeils 11 entsteht.

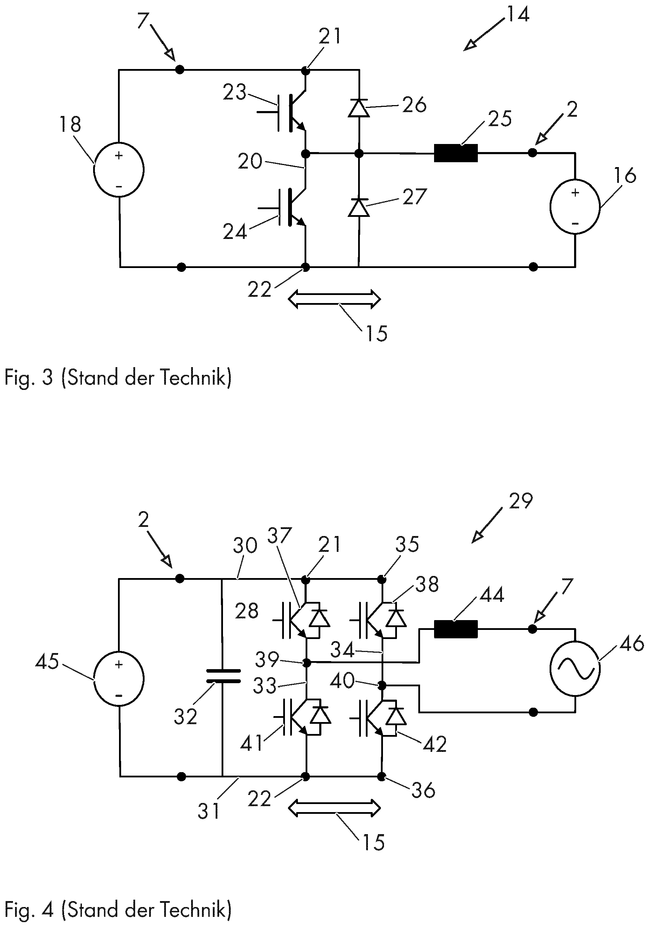

Die Figur 3 zeigt einen Stromrichter in Form einer Halbbrückenanordnung 14 gemäß dem Stand der Technik in schematischer Darstellung. Mittels der Halbbrückenanordnung 14 lässt sich eine Gleichspannung bidirektional stellen, so dass ein elektrischer Energiefluss in beiden Richtungen des Doppelpfeiles 15 ermöglicht ist. Aus diesem Grund ist die Bezeichnung des Eingangs 2 und des Ausgangs 7 des Stromrichters in der Figur willkürlich gewählt. Am Eingang 2 ist eine Gleichspannungsquelle 16 angeschlossen, bei der es sich beispielsweise um eine Batterie handeln kann, die sowohl als Gleichspannungsquelle als auch als Last betrieben werden kann. Am Ausgang 7 ist eine Gleichspannungsquelle 18 angeschlossen, bei der es sich beispielsweise um einen Zwischenkreis eines Wechselrichters handeln kann, der DC-seitig an eine Solaranlage (nicht dargestellt) und AC-seitig an ein Wechselspannungsnetz (nicht dargestellt) angeschlossen sein kann. Zum Stellen der Gleichspannung umfasst die Halbbrückenanordnung 14 eine Halbbrücke 20, welche sich von einem Anschlusspunkt 21 zu einem Anschlusspunkt 22 erstreckt und eine Drossel 25. Die Halbbrücke 20 umfasst eine Reihenschaltung aus einem High-Side-Leistungshalbleiterschalter 23 und einem Low-Side-Leistungshalbleiterschalter 24. Der High-Side-Leistungshalbleiterschalter 23 umfasst eine Diode 26 und der Low-Side-Leistungshalbleiterschalter 24 umfasst eine Diode 27. Zum Stellen der Gleichspannung werden die beiden Leistungshalbleiterschalter der Halbbrücke 20 an ihren Steueranschlüssen von jeweils einer Treiberschaltung (nicht dargestellt) angesteuert, so dass je nach Bedarf ein elektrischer Energiefluss in einer der beiden Richtungen des Doppelpfeiles 15 entsteht.

Die Figur 4 zeigt einen Wechselrichter 29 gemäß dem Stand der Technik in schematischer Darstellung. Mittels des Wechselrichters 29 lässt sich eine Gleichspannung in eine Wechselspannung umwandeln und umgekehrt, so dass ein elektrischer Energiefluss in Richtung des Doppelpfeiles 15 ermöglicht ist. Aus diesem Grund ist die Bezeichnung des Eingangs 2 und des Ausgangs 7 des Stromrichters in der Figur willkürlich gewählt. Der Wechselrichter 29 umfasst einen Zwischenkreis 28 mit einem ersten Zwischenkreispol 30 und einem zweiten Zwischenkreispol 31, die über einen Zwischenkreiskondensator 32 miteinander verbunden sind. Der Wechselrichter 29 umfasst zwei Halbbrücken 33 und 34, die sich zwischen einem mit dem ersten Zwischenkreispol 30 verbundenen Anschlusspunkt 21 bzw. 35 und einem mit dem zweiten Zwischenkreispol 31 verbundenen Anschlusspunkt 22 bzw. 36 erstrecken und ausgehend von dem Anschlusspunkt 21 bzw. 35 jeweils eine Reihenschaltung aus einem High-Side-Leistungshalbleiterschalter 37 bzw. 38, einem Abzweigpunkt 39 bzw. 40 und einem Low-Side-Leistungshalbleiterschalter 41 bzw. 42 umfassen. Dem Abzweigpunkt 39 ist in Richtung des Ausgangs 7 eine Drossel 44 nachgeschaltet. An den Eingang 2 des Wechselrichters 29 ist ein Gleichspannungsgenerator 45 und an den Ausgang 7 des Wechselrichters 29 ein Wechselspannungsnetz 46 angeschlossen. Zum Stellen der elektrischen Spannung sind Treiberschaltungen (nicht dargestellt) zum Ansteuern und Schalten der Leistungshalbleiterschalter angeordnet, so dass je nach Bedarf ein elektrischer Energiefluss in beide Richtungen des Doppelpfeils 15 ermöglicht ist.

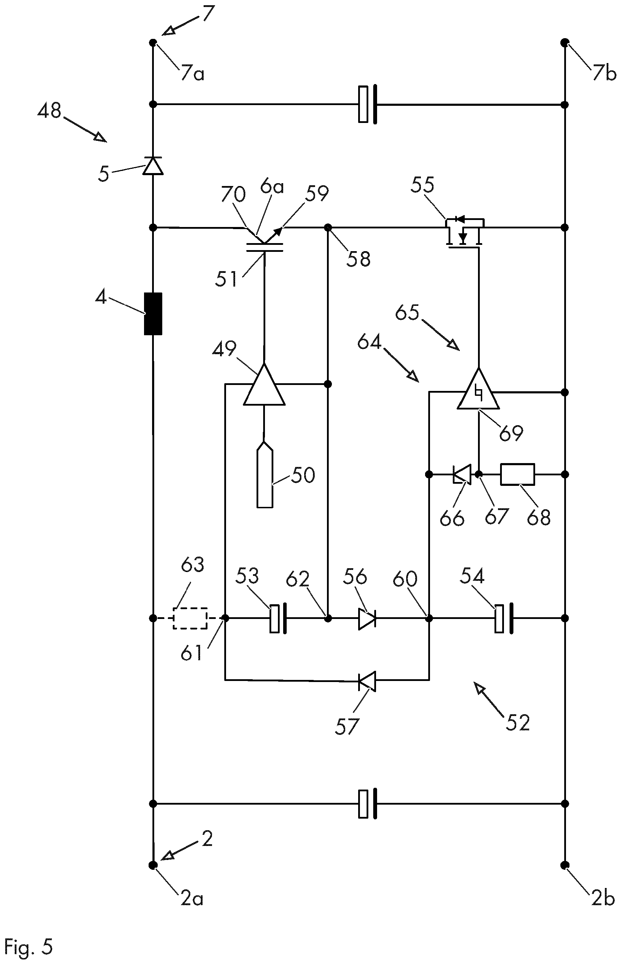

Die Figur 5 zeigt einen Stromrichter in Form eines Hochsetzstellers 48 gemäß einem ersten Ausführungsbeispiel der Erfindung in schematischer Darstellung. Zur Ansteuerung eines ersten Leistungshalbleiterschalters 6a ist eine Treiberschaltung 49 an einen Steuereingang 51 des Leistungshalbleiterschalters 6a angeschlossen. Die Treiberschaltung 49 ist mit einem Taktgeber 50 in einem Bauteil integriert. Zur elektrischen Spannungsversorgung der Treiberschaltung 49 ist eine Hilfs-Schaltungsanordnung 52 umfasst, die einen Versorgungskondensator 53, einen Hilfskondensator 54, einen selbstsperrenden Hilfshalbleiterschalter 55, eine Diode 56 und eine Bootstrapdiode 57 umfasst. Der Hilfshalbleiterschalter 55 ist über einen ersten Anschlusspunkt 58 an einem Bezugspotentialanschluss 59 des ersten Leistungshalbleiterschalters 6a angeschlossen und ist in eine Grundschaltung des Hochsetzstellers 48 integriert. Ausgehend von dem ersten Anschlusspunkt 58 ist eine Reihenschaltung der Diode 56, eines zweiten Anschlusspunktes 60 und des Hilfskondensators 54 umfasst, die parallel zum Hilfshalbleiterschalter 55 angeordnet ist. Die Treiberschaltung 49 ist zu ihrer elektrischen Spannungsversorgung an den Versorgungskondensator 53 angeschlossen, der wiederum mit einem ersten Anschluss 61 über die Bootstrapdiode 57 mit dem zweiten Anschlusspunkt 60 und mit einem zweiten Anschluss 62 mit dem Bezugspotentialanschluss 59 elektrisch verbunden ist.

Die Hilfs-Schaltungsanordnung 52 umfasst zudem zur Ansteuerung des Hilfshalbleiterschalters 55 eine Ansteuerschaltung 64, die als Komparator-Schaltung 65 ausgebildet ist. Diese ist mit zwei Versorgungsanschlüssen parallel zum Hilfskondensator 54 geschaltet. Zusätzlich ist parallel zum Hilfskondensator 54 eine Reihenschaltung aus einer Z-Diode 66 in Sperrrichtung, einem achten Anschlusspunkt 67 und einem Widerstand 68 angeordnet, wobei der nichtinvertierende Eingang 69 der Komparator-Schaltung 65 am achten Anschlusspunkt 67 und der invertierende Eingang (nicht dargestellt) der Komparator-Schaltung 65 an einem Referenzpotential (nicht dargestellt) angeschlossen sind.

Sowohl im Betrieb als auch im Anlauffall des Hochsetzstellers 48 müssen seine notwendigen Komponenten, beispielsweise die Treiberschaltung 49, mit elektrischer Leistung versorgt werden. Im Anlauffall kann beispielsweise mindestens zwischen einem ersten Anschluss 2a und einem zweiten Anschluss 2b des Eingangs 2 des Hochsetzstellers 48 eine Gleichspannung anliegen, die beispielsweise von einem DC-Generator (nicht dargestellt) bereitgestellt wird. Somit liegt im Anlauffall zwischen dem Bezugspotentialanschluss 59 des ersten Leistungshalbleiterschalters 6a und einem weiteren Hauptanschluss 70 eine Gleichspannung an, die zu einem Leckstrom über den ersten Leistungshalbleiterschalter 6a führt, so dass bei gesperrtem Hilfshalbleiterschalter 55 durch Stromfluss über den ersten Leistungshalbleiterschalter 6a der Hilfskondensator 54 geladen wird. Überschreitet die Ladung des Hilfskondensators 54 einen ersten Schwellwert, stellt die Komparator-Schaltung 65 am Steuereingang des Hilfshalbleiterschalters 55 eine den Schalter durchschaltendes Steuersignal bereit, so dass bei leitendem Hilfshalbleiterschalter 55 und mindestens teilweise geladenem Hilfskondensator 54 der Versorgungskondensator 53 über die Bootstrapdiode 57 von dem Hilfskondensator 54 geladen wird. Hierbei sinkt die Ladung des Hilfskondensators unter einen zweiten Schwellwert ab, so dass die Komparator-Schaltung am Steuereingang des Hilfshalbleiterschalters 55 kein Steuersignal mehr bereitstellt und dieser wieder in einen gesperrten Schaltzustand wechselt und der Hilfskondensator erneut aufgeladen wird. Im Betrieb des Hochsetzstellers 48 fließt ein Arbeitsstrom über den ersten Leistungshalbleiterschalter 6a, so dass durch mehrfaches Wiederholen des Auflade-Vorgangs dem Versorgungskondensators 53 eine elektrische Leistung zugeführt wird, um die Treiberschaltung 49 im Betrieb zu versorgen. Zur Verkürzung der Anlaufzeit kann optional ein Anlaufwiderstand 63 angeordnet sein, der den ersten Anschluss 2a des Eingangs mit dem ersten Anschluss 61 des Versorgungskondensators 53 elektrisch verbindet.

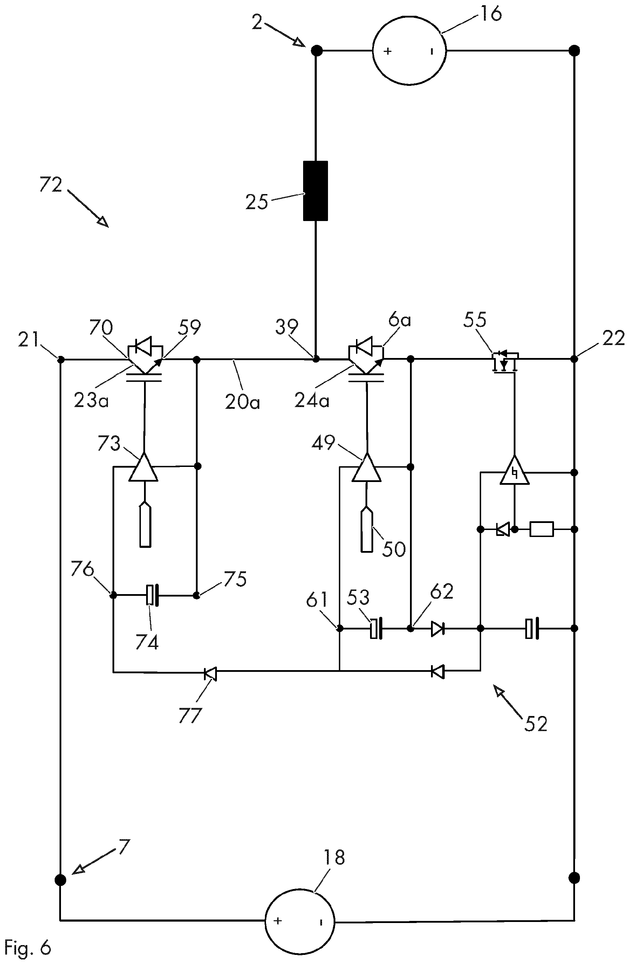

Die Figur 6 zeigt eine Halbbrückenanordnung 72 gemäß einem zweiten Ausführungsbeispiel der Erfindung in schematischer Darstellung. Im Folgenden sei im Wesentlichen auf die Unterschiede der in Figur 6 dargestellten Halbbrückenanordnung 72 gegenüber der in Figur 3 dargestellten Halbbrückenanordnung 14 des Standes der Technik eingegangen. Die Halbbrücke 20a der Halbbrückenanordnung 72, die sich zwischen dem Anschlusspunkt 21 und 22 erstreckt, umfasst ebenfalls ausgehend von dem Anschlusspunkt 21 eine Reihenschaltung aus einem High-Side-Leistungshalbleiterschalter 23a, einem Abzweigpunkt 39 und einem Low-Side-Leistungshalbleiterschalter 24a, wobei bei dem dargestellten Ausführungsbeispiel die beiden Leistungshalbleiterschalter jeweils eine integrierte Bodydiode aufweisen und ein Hilfshalbleiterschalter 55 in die Halbbrücke 20a integriert ist. Zur Versorgung der Treiberschaltung 49 des Low-Side-Leistungshalbleiterschalter 24a ist dieser als ein erster Leistungshalbleiterschalter ausgebildet, so dass eine Treiberschaltung 49 zur Ansteuerung des Low-Side-Leistungshalbleiterschalters 24a mittels einer den Hilfshalbleiterschalter 55 umfassende Hilfs-Schaltungsanordnung 52 mit elektrischer Spannung versorgt wird. Bezüglich der Hilfs-Schaltungsanordnung 52 wird auf die Figurenbeschreibung der Figur 5 zu Bezugszeichen 52 verwiesen. Die Halbbrückenanordnung 72 weist zur Ansteuerung des High-Side-Leistungshalbleiterschalters 23a eine Treiberschaltung 73 auf, die zu ihrer elektrischen Spannungsversorgung mit einem Versorgungskondensator 74 elektrisch verbunden ist. Zur Aufladung des Versorgungskondensators 74 zur elektrischen Spannungsversorgung der Treiberschaltung 73 zur Ansteuerung des High-Side-Leistungshalbleiterschalter 23a ist dieser mit einem Anschluss 75 mit einem Bezugspotentialanschluss 59 des High-Side-Leistungshalbleiterschalter 23a und mit einem weiteren Anschluss 76 über eine weitere Bootstrapdiode 77 mit dem ersten Anschluss 61 des von der Hilfs-Schaltungsanordnung 52 umfassten Versorgungskondensators 53 elektrisch verbunden. Somit kann bei dem dargestellten Ausführungsbeispiel die Treiberschaltung 73 zur Ansteuerung des High-Side-Leistungshalbleiterschalters 23a im Betrieb der Halbbrückenanordnung 72 ebenfalls energieeffizient mit elektrischer Leistung versorgt werden.

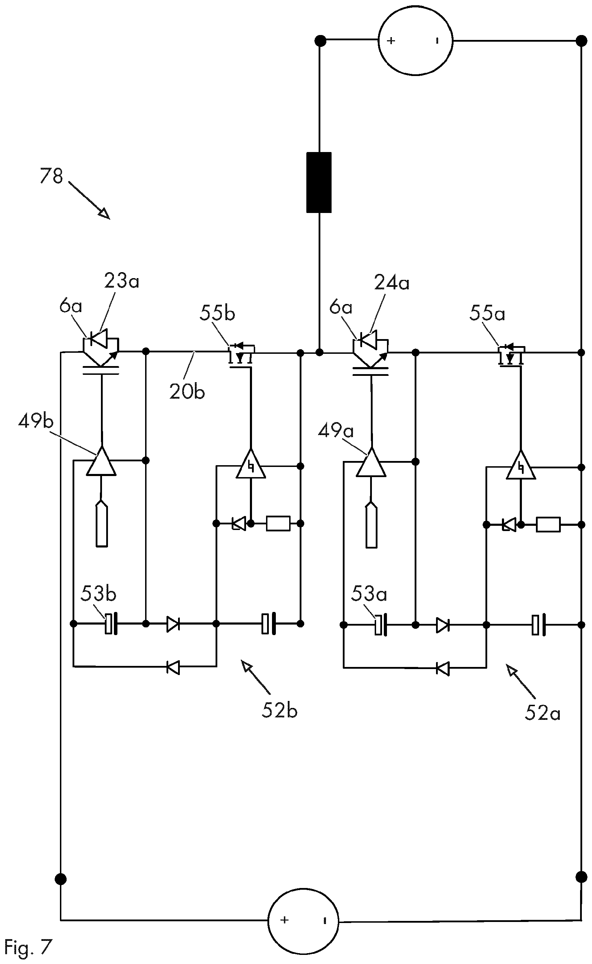

Die Figur 7 zeigt eine Halbbrückenanordnung 78 gemäß einem dritten Ausführungsbeispiel der Erfindung in schematischer Darstellung. Im Unterschied zum Ausführungsbeispiel der Figur 6 ist eine alternative elektrische Spannungsversorgung der Treiberschaltung des High-Side-Leistungshalbleiterschalters 23a dargestellt. Hierzu sind sowohl der High-Side-Leistungshalbleiterschalter 23a als auch der Low-Side-Leistungshalbleiterschalter 24a jeweils als ein erster Leistungshalbleiterschalter ausgebildet. Es werden somit beide Treiberschaltungen 49a, 49b zur Ansteuerung des High-/ und Low-Side-Leistungshalbleiterschalters 23a, 24a über jeweils eine eigene Hilfs-Schaltungsanordnung 52a, 52b mit elektrischer Spannung versorgt. Somit ermöglicht dieses alternative Ausführungsbeispiel ebenfalls eine energieeffiziente elektrische Spannungsversorgung der Treiberschaltungen zur Ansteuerung der beiden Leistungshalbleiterschalter für den Anlauffall und im Betrieb der Halbbrückenanordnung 78. Die elektrische Spannungsversorgung der Treiberschaltungen der Figur 6 und Figur 7 lassen sich auch auf leistungselektronische Vorrichtungen mit mehr als einer Halbbrücke übertragen, beispielsweise bei ein- oder dreiphasigen Wechselrichtern mit entsprechend ausgebildeter Wechselrichterbrücke.

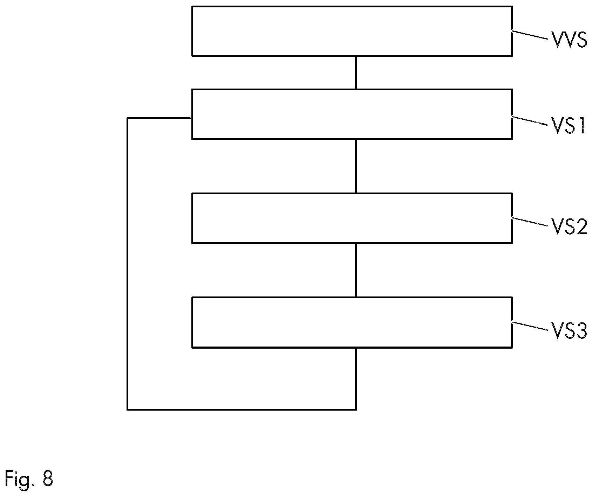

Die Figur 8 zeigt ein Ablaufdiagramm eines Verfahrens zur elektrischen Spannungsversorgung einer Treiberschaltung eines Leistungshalbleiterschalters gemäß einem vierten Ausführungsbeispiels der Erfindung. Bei dem Verfahren wird zunächst in einem vorbereitenden Schritt VVS für einen Anlauffall eine Spannung zwischen einem Bezugspotentialanschluss des Leistungshalbleiterschalters und einem weiteren Hauptanschluss des Leistungshalbleiterschalters angelegt. In einem ersten Verfahrensschritt VS1 wird ein Hilfskondensator mittels mindestens eines Teils eines über den Leistungshalbleiterschalter fließenden Stroms aufgeladen während eines gesperrten Schaltzustandes eines selbstsperrenden Hilfsschalters. In einem zweiten Verfahrensschritt VS2 wird der Hilfsschalter bei einem Überschreiten eines ersten Schwellwertes der Ladespannung des Hilfskondensators dieser durchgeschaltet und mindestens ein Teil der Ladung des Hilfskondensators wird an einen Versorgungskondensator für die elektrische Spannungsversorgung der Treiberschaltung abgegeben, und in einem dritten Verfahrensschritt VS3 wird der Hilfsschalter bei einem Unterschreiten eines geringeren, zweiten Schwellwertes der Ladespannung des Hilfskondensators dieser wieder in einen gesperrten Schaltzustand überführt, wobei durch mehrfaches Wiederholen der drei Schritte VS1 - VS3 dem Versorgungskondensator eine elektrische Leistung zugeführt wird, um die Treiberschaltung im Betrieb des Leistungshalbleiterschalters zu versorgen.

### Bezugszeichenliste

- 1a: Leistungselektronische Vorrichtung
- 1b: Stromrichter
- 1, 48: Hochsetzsteller
- 2: Eingang
- 2a, 2b: Anschluss
- 3: Gleichspannungsgenerator
- 4: Drossel
- 5: Diode
- 6: Leistungshalbleiterschalter
- 6a: Erster Leistungshalbleiterschalter
- 7: Ausgang
- 8: Pfeil
- 9: Tiefsetzsteller
- 10: Gleichspannungsquelle
- 11: Pfeil
- 14, 72, 78: Halbbrückenanordnung
- 15: Doppelpfeils
- 16: Gleichspannungsquelle
- 18: Gleichspannungsquelle
- 20, 33, 34, 20a, 20b: Halbbrücke
- 21, 35, 58: Anschlusspunkt
- 22, 36, 60, 67: Anschlusspunkt
- 23, 37, 38, 23a: High-Side-Leistungshalbleiterschalter
- 24, 41, 42, 24a: Low-Side-Leistungshalbleiterschalter
- 25, 44: Drossel
- 26, 56: Diode
- 27: Diode
- 28: Zwischenkreis
- 29: Wechselrichter
- 30: Zwischenkreispol
- 31: Zwischenkreispol
- 32: Zwischenkreiskondensator
- 39, 40: Abzweigpunkt
- 45: Gleichspannungsgenerator
- 46: Wechselspannungsnetz
- 49, 73, 49a, 49b: Treiberschaltung
- 50: Taktgeber
- 51: Steuereingang
- 52, 52a, 52b: Hilfs-Schaltungsanordnung
- 53, 74: Versorgungskondensator
- 54: Hilfskondensator
- 55: Hilfshalbleiterschalter
- 57: Bootstrapdiode
- 59: Bezugspotentialanschluss
- 61: Erster Anschluss
- 62: Zweiter Anschluss
- 63: Anlaufwiderstand
- 64: Ansteuerschaltung
- 65: Komparator-Schaltung
- 66: Z-Diode
- 68: Widerstand
- 69: Nichtinvertierender Eingang
- 70: Weiterer Hauptanschluss
- 75: Anschluss
- 76: Weiterer Anschluss
- 77: Weitere Bootstrapdiode
- VVS: Vorbereitender Schritt
- VS1, VS2, VS3: Verfahrensschritt

## Patentansprüche

1. Leistungselektronische Vorrichtung (1a), insbesondere Stromrichter (1b), mit einem ersten Leistungshalbleiterschalter (6a), einer Treiberschaltung (49, 49a, 49b) zur Ansteuerung des ersten Leistungshalbleiterschalter (6a) und einer elektrischen Hilfs-Schaltungsanordnung (52, 52a, 52b) zur elektrischen Spannungsversorgung der Treiberschaltung (49, 49a, 49b), wobei die Hilfs-Schaltungsanordnung (52, 52a, 52b) einen Versorgungs- (53, 53a, 53b) und einen Hilfskondensator (54), einen selbstsperrenden Hilfshalbleiterschalter (55, 55a, 55b), eine Diode (56) und eine Bootstrapdiode (57) umfasst, wobei
- der Hilfshalbleiterschalter (55, 55a, 55b) über einen ersten Anschlusspunkt (58) an einem Bezugspotentialanschluss (59) des ersten Leistungshalbleiterschalters (6a) angeschlossen ist,
- ausgehend von dem ersten Anschlusspunkt (58) eine Reihenschaltung der Diode (56), eines zweiten Anschlusspunktes (60) und des Hilfskondensators (54) parallel zum Hilfshalbleiterschalter (55, 55a, 55b) angeordnet ist, so dass bei gesperrtem Hilfshalbleiterschalter (55, 55a, 55b) durch Stromfluss über den ersten Leistungshalbleiterschalter (6a) der Hilfskondensator (54) geladen wird,
- die Treiberschaltung (49, 49a, 49b) zu ihrer elektrischen Spannungsversorgung an den Versorgungskondensator (53, 53a, 53b) angeschlossen ist, und
- der Versorgungskondensator (53, 53a, 53b) mit einem ersten Anschluss (61) über die Bootstrapdiode (57) mit dem zweiten Anschlusspunkt (60) und mit einem zweiten Anschluss (62) mit dem Bezugspotentialanschluss (59) elektrisch verbunden ist, so dass bei leitendem Hilfshalbleiterschalter (55, 55a, 55b) und mindestens teilweise geladenem Hilfskondensator (54) der Versorgungskondensator (53, 53a, 53b) über die Bootstrapdiode (57) von dem Hilfskondensator (54) geladen wird, wobei die Hilfs-Schaltungsanordnung (52, 52a, 52b) eine Ansteuerschaltung (64) umfasst, welche dazu ausgebildet und eingerichtet ist, in Abhängigkeit einer Ladespannung des Hilfskondensators (54) ein Steuersignal zum Schalten des Hilfshalbleiterschalters (55, 55a, 55b) an einem Steuer-Eingang des Hilfshalbleiterschalters (55, 55a, 55b) bereit zu stellen.

2. Leistungselektronische Vorrichtung (1a) nach Anspruch 1, wobei die Ansteuerschaltung (64) dazu ausgebildet und eingerichtet ist, bei einer einen ersten Schwellwert überschreitenden Ladespannung des Hilfskondensators (54) ein den Hilfshalbleiterschalter (55, 55a, 55b) durchschaltendes Steuersignal am SteuerEingang des Hilfshalbleiterschalters (55, 55a, 55b) bereitzustellen, und bei einer einen zweiten Schwellwert unterschreitenden Ladespannung des Hilfskondensators (54), der geringer ist als der erste Schwellwert, ein den Hilfshalbleiterschalter (55, 55a, 55b) sperrendes Steuersignal am Steuer-Eingang des Hilfshalbleiterschalters (55, 55a, 55b) bereitzustellen, wobei der erste Schwellwert mindestens der Höhe einer Versorgungspannung der Treiberschaltung (49, 49a, 49b) entspricht.

3. Leistungselektronische Vorrichtung (1a) nach einem der Ansprüche 1 oder-3 2, wobei die Ansteuerschaltung (64) ein Zweipunktregler, insbesondere eine Komparator-Schaltung (65), oder ein Monoflop oder eine PWM-Regelung oder eine Frequenzregelung ist.

4. Leistungselektronische Vorrichtung (1a) nach einem der Ansprüche 1 bis-4 3, wobei die Ansteuerschaltung (64) derart ausgebildet und eingerichtet und mit dem Hilfskondensator (54) elektrisch verbunden ist, dass die elektrische Spannungsversorgung der Ansteuerschaltung (64) mittels des Hilfskondensators (54) erfolgt.

5. Leistungselektronische Vorrichtung (1a) nach einem der vorhergehenden Ansprüche, wobei der Hilfshalbleiterschalter (55, 55a, 55b) die gleiche Polarität aufweist, wie der erste Leistungshalbleiterschalter (6a).

6. Leistungselektronische Vorrichtung (1a) nach einem der vorhergehenden Ansprüche, wobei der erste Leistungshalbleiterschalter (6a) selbstsperrend ausgebildet ist und im gesperrten Schaltzustand bei einer anliegenden elektrischen Spannung zwischen dem Bezugspotentialanschluss (59) und einem weiteren Hauptanschluss (70) des ersten Leistungshalbleiterschalters (6a) einen Leckstrom aufweist.

7. Leistungselektronische Vorrichtung (1a) nach einem der vorhergehenden Ansprüche, wobei die Hilfs-Schaltungsanordnung (52, 52a, 52b), insbesondere der Hilfshalbleiterschalter (55, 55a, 55b), ausschließlich der Versorgung mindestens einer Treiberschaltung (49, 49a, 49b, 73) dient.

8. Leistungselektronische Vorrichtung (1a) nach einem der vorhergehenden Ansprüche, wobei die Treiberschaltung (49, 49a, 49b) mit einem Taktgeber (50) integriert ausgebildet ist, wobei der Taktgeber (50) zur Generierung eines Pulsmusters des durch die Treiberschaltung (49, 49a, 49b) bereitgestellten Steuersignals ausgebildet ist.

9. Leistungselektronische Vorrichtung (1a) nach einem der vorhergehenden Ansprüche, wobei eine Halbbrücke (20a, 20b) umfasst ist, welche ausgehend von einem dritten Anschlusspunkt (21) eine Reihenschaltung aus einem High-Side-Leistungshalbleiterschalter (23a), einen Abzweigpunkt (39) und einen Low-Side-Leistungshalbleiterschalter (24a) und einen vierten Anschlusspunkt (22) umfasst, wobei der erste Leistungshalbleiterschalter (6a) der Low-Side-Leistungshalbleiterschalter (24a) ist, wobei insbesondere die leistungselektronische Vorrichtung (1a) ein DC/DC-Steller oder ein Wechselrichter (29) ist, wobei optional ein Zwischenkreis (28) umfasst ist mit einer den dritten Anschlusspunkt (21) mit dem vierten Anschlusspunkt (22) über einen oder mehrere in Reihe oder parallel geschaltete Zwischenkreiskondensatoren verbindenden elektrischen Verbindung.

10. Leistungselektronische Vorrichtung (1a) nach Anspruch 9, wobei entweder sowohl für den High-Side-Leistungshalbleiterschalter (23a) als auch den Low-Side-Leistungshalbleiterschalter (24a) jeweils eine Treiberschaltung (49a, 49b) zur Ansteuerung des jeweiligen Leistungshalbleiterschalters und jeweils eine eigene elektrischen Hilfs-Schaltungsanordnung (52a, 52b) zur elektrischen Spannungsversorgung der Treiberschaltung (49a, 49b) umfasst ist, so dass sowohl der High-Side-Leistungshalbleiterschalter (23a) als auch der Low-Side-Leistungshalbleiterschalter jeweils (24a) als ein erster Leistungshalbleiterschalter (6a) ausgebildet sind, oder zur Ansteuerung des High-Side-Leistungshalbleiterschalters (23a) eine Treiberschaltung (73) und zur elektrischen Spannungsversorgung dieser Treiberschaltung (73) ein Versorgungskondensator (74) umfasst ist, der mit einem Anschluss (75) mit einem Bezugspotentialanschluss (59) des High-Side-Leistungshalbleiterschalters (23a) elektrisch verbunden ist und mit einem weiteren Anschluss (76) über eine weitere Bootstrapdiode (77) mit dem ersten Anschluss (61) des von der Hilfs-Schaltungsanordnung (52) umfassten Versorgungskondensators (53) zur elektrischen Spannungsversorgung der Treiberschaltung (49) zur Ansteuerung des Low-Side-Leistungshalbleiterschalters (24a) elektrisch verbunden ist.

11. Leistungselektronische Vorrichtung (1a) nach einem der Ansprüche 9 oder 10, wobei der High-Side-Leistungshalbleiterschalter (23a) und der Low-Side-Leistungshalbleiterschalter (24a) selbstsperrend sind und in gesperrtem Schaltzustand bei anliegender elektrischer Spannung zwischen ihrem Bezugspotentialanschluss (59) und ihrem weiteren Hauptanschluss (70) einen Leckstrom aufweisen.

12. Verfahren zur elektrischen Spannungsversorgung einer Treiberschaltung (49) eines Leistungshalbleiterschalters, wobei die Treiberschaltung (49, 49a, 49b) von einem Versorgungskondensator (53, 53a, 53b) mit Spannung versorgt wird, wobei zur Aufladung des Versorgungskondensators (53, 53a, 53b) ein Hilfskondensator (54) mittels eines über den Leistungshalbleiterschalter fließenden Stroms aufgeladen wird während eines gesperrten Schaltzustandes eines selbstsperrenden Hilfsschalters und der Versorgungskondensator (53) vom Hilfskondensator (54) aufgeladen wird, wenn der selbstsperrende Hilfsschalter durchgeschaltet ist, wobei der Hilfsschalter in Abhängigkeit einer Ladespannung des Hilfskondensators (54) durchgeschaltet wird.

13. Verfahren nach Anspruch 12, wobei der Hilfsschalter durchgeschaltet wird, wenn eine Ladespannung des Hilfskondensators (54) einen ersten Schwellwert überschreitet (VS2) und der Hilfsschalter gesperrt wird, wenn die Ladespannung des Hilfskondensators (54) einen zweiten Schwellwert unterschreitet, wobei der zweite Schwellwert geringer ist als der erste Schwellwert (VS3).

14. Verfahren nach einem der Ansprüche 12 oder 13, wobei der selbstsperrende Hilfsschalter an einen Bezugspotentialanschluss (59) des Leistungshalbleiters angeschlossen ist, so dass in einem ersten Verfahrensschritt (VS1) bei gesperrtem Hilfsschalter mindestens ein Teil des über den Leistungshalbleiterschalter fließenden Stroms auf den Hilfskondensator umgeleitet wird und diesen mindestens teilweise auflädt, wobei in einem zweiten Verfahrensschritt (VS2) der Hilfsschalter durchgeschaltet wird und mindestens einen Teil der Ladung des Hilfskondensators an den Versorgungskondensator abgibt, und in einem dritten Verfahrensschritt (VS3) der Hilfsschalter wieder in einen gesperrten Schaltzustand überführt wird, so dass durch mehrfaches Wiederholen der drei Verfahrensschritte dem Versorgungskondensator eine elektrische Leistung zugeführt wird, um die Treiberschaltung im Betrieb zu versorgen.

15. Verfahren nach einem der Ansprüche 12 bis 14, wobei das Verfahren mit einer leistungselektronischen Vorrichtung (1a) nach einem der Ansprüche 1 bis 11 durchgeführt wird.

## Claims

1. A power electronics device (1a), in particular a power converter (1b), having a first power semiconductor switch (6a), a driver circuit (49, 49a, 49b) for driving the first power semiconductor switch (6a) and an electrical auxiliary circuit arrangement (52, 52a, 52b) for supplying electrical voltage to the driver circuit (49, 49a, 49b), wherein the auxiliary circuit arrangement (52, 52a, 52b) comprises a supply capacitor (53, 53a, 53b) and an auxiliary capacitor (54), a normally off auxiliary semiconductor switch (55, 55a, 55b), a diode (56) and a bootstrap diode (57), wherein
- the auxiliary semiconductor switch (55, 55a, 55b) is connected to a reference potential connection (59) of the first power semiconductor switch (6a) via a first connection point (58),
- starting from the first connection point (58), a series connection of the diode (56), a second connection point (60) and the auxiliary capacitor (54) is arranged in parallel with the auxiliary semiconductor switch (55, 55a, 55b) such that, when the auxiliary semiconductor switch (55, 55a, 55b) is in the off state, the auxiliary capacitor (54) is charged by the flow of current through the first power semiconductor switch (6a),
- the driver circuit (49, 49a, 49b) is connected to the supply capacitor (53, 53a, 53b) for its electrical voltage supply, and
- the supply capacitor (53, 53a, 53b) is electrically connected by a first connection (61) to the second connection point (60) via the bootstrap diode (57) and by a second connection (62) to the reference potential connection (59), such that, when the auxiliary semiconductor switch (55, 55a, 55b) is in the on state and the auxiliary capacitor (54) is at least partially charged, the supply capacitor (53, 53a, 53b) is charged by the auxiliary capacitor (54) via the bootstrap diode (57), wherein the auxiliary circuit arrangement (52, 52a, 52b) comprises a drive circuit (64) that is designed and configured to provide a control signal for switching the auxiliary semiconductor switch (55, 55a, 55b) at a control input of the auxiliary semiconductor switch (55, 55a, 55b) on the basis of a charging voltage of the auxiliary capacitor (54).

2. The power electronics device (1a) as claimed in claim 1, wherein the drive circuit (64) is designed and configured to provide a control signal that puts the auxiliary semiconductor switch (55, 55a, 55b) into the on state at the control input of the auxiliary semiconductor switch (55, 55a, 55b) when a charging voltage of the auxiliary capacitor (54) exceeds a first threshold value, and to provide a control signal that puts the auxiliary semiconductor switch (55, 55a, 55b) into the off state at the control input of the auxiliary semiconductor switch (55, 55a, 55b) when a charging voltage of the auxiliary capacitor (54) falls below a second threshold value that is lower than the first threshold value, wherein the first threshold value corresponds at least to the magnitude of a supply voltage to the driver circuit (49, 49a, 49b).

3. The power electronics device (1a) as claimed in either of claims 1 or 2, wherein the drive circuit (64) is a two-level regulator, in particular a comparator circuit (65), or a monoflop or a PWM controller or frequency controller.

4. The power electronics device (1a) as claimed in one of claims 1 to 3, wherein the drive circuit (64) is designed and configured and electrically connected to the auxiliary capacitor (54) such that the drive circuit (64) is supplied with electrical voltage by way of the auxiliary capacitor (54).

5. The power electronics device (1a) as claimed in one of the preceding claims, wherein the auxiliary semiconductor switch (55, 55a, 55b) has the same polarity as the first power semiconductor switch (6a).

6. The power electronics device (1a) as claimed in one of the preceding claims, wherein the first power semiconductor switch (6a) is designed to be normally off and, in the off switching state, has a leakage current when an electrical voltage is applied between the reference potential connection (59) and a further main connection (70) of the first power semiconductor switch (6a).

7. The power electronics device (1a) as claimed in one of the preceding claims, wherein the auxiliary circuit arrangement (52, 52a, 52b), in particular the auxiliary semiconductor switch (55, 55a, 55b), serves exclusively to supply at least one driver circuit (49, 49a, 49b, 73).

8. The power electronics device (1a) as claimed in one of the preceding claims, wherein the driver circuit (49, 49a, 49b) is designed to be integrated with a clock generator (50), wherein the clock generator (50) is designed to generate a pulse pattern of the control signal provided by the driver circuit (49, 49a, 49b).

9. The power electronics device (1a) as claimed in one of the preceding claims, comprising a half-bridge (20a, 20b) that, starting from a third connection point (21), comprises a series connection consisting of a high-side power semiconductor switch (23a), a branch point (39) and a low-side power semiconductor switch (24a) and a fourth connection point (22), wherein the first power semiconductor switch (6a) is the low-side power semiconductor switch (24a), wherein the power electronics device (1a) is in particular a DC/DC converter or an inverter (29), wherein optionally a link circuit (28) having an electrical connection connecting the third connection point (21) to the fourth connection point (22) via one or more series-connected or parallelconnected link circuit capacitors is comprised.

10. The power electronics device (1a) as claimed in claim 9, either comprising for both the high-side power semiconductor switch (23a) and the low-side power semiconductor switch (24a) a respective driver circuit (49a, 49b) for driving the respective power semiconductor switch and a respective separate electrical auxiliary circuit arrangement (52a, 52b) for supplying electrical voltage to the driver circuit (49a, 49b), such that both the high-side power semiconductor switch (23a) and the low-side power semiconductor switch (24a) are each designed as a first power semiconductor switch (6a), or comprising a driver circuit (73) for driving the high-side power semiconductor switch (23a) and a supply capacitor (74) for the electrical voltage supply of this driver circuit (73), which supply capacitor is electrically connected by a connection (75) to a reference potential connection (59) of the high-side power semiconductor switch (23a) and is electrically connected by a further connection (76) to the first connection (61) of the supply capacitor (53) included in the auxiliary circuit arrangement (52) via a further bootstrap diode (77) in order to supply electrical voltage to the driver circuit (49) for driving the low-side power semiconductor switch (24a).

11. The power electronics device (1a) as claimed in claims 9 or 10, wherein the high-side power semiconductor switch (23a) and the low-side power semiconductor switch (24a) are normally off and, in the off switching state, have a leakage current when an electrical voltage is applied between their reference potential connection (59) and their further main connection (70).

12. A method for supplying electrical voltage to a driver circuit (49) of a power semiconductor switch, wherein the driver circuit (49, 49a, 49b) is supplied with voltage by a supply capacitor (53, 53a, 53b), wherein, in order to charge the supply capacitor (53, 53a, 53b), an auxiliary capacitor (54) is charged by way of a current flowing through the power semiconductor switch during an off switching state of a normally off auxiliary switch, and the supply capacitor (53) is charged by the auxiliary capacitor (54) when the normally off auxiliary switch is in the on state, wherein the auxiliary switch is put into the on state on the basis of a charging voltage of the auxiliary capacitor (54).

13. The method as claimed in claim 12, wherein the auxiliary switch is put into the on state when a charging voltage of the auxiliary capacitor (54) exceeds a first threshold value (VS2) and the auxiliary switch is put into the off state when the charging voltage of the auxiliary capacitor (54) falls below a second threshold value, wherein the second threshold value is lower than the first threshold value (VS3).

14. The method as claimed in claims 12 or 13, wherein the normally off auxiliary switch is connected to a reference potential connection (59) of the power semiconductor, such that, in a first method step (VS1), when the auxiliary switch is in the off state, at least part of the current flowing through the power semiconductor switch is diverted to the auxiliary capacitor and at least partially charges the same, wherein, in a second method step (VS2), the auxiliary switch is put into the on state and releases at least part of the charge of the auxiliary capacitor to the supply capacitor, and, in a third method step (VS3), the auxiliary switch is put back into an off switching state, such that electric power is supplied to the supply capacitor by repeating the three method steps multiple times, in order to supply the driver circuit during operation.

15. The method as claimed in one of claims 12 to 14, wherein the method is performed using a power electronics device (1a) as claimed in one of claims 1 to 11.

## Revendications

1. Dispositif électronique de puissance (1a), en particulier convertisseur (1b), comprenant un premier commutateur à semi-conducteur de puissance (6a), un circuit d'attaque (49, 49a, 49b) pour la commande du premier commutateur à semi-conducteur de puissance (6a) et un circuit auxiliaire (52, 52a, 52b) pour fournir une tension électrique au circuit d'attaque (49, 49a, 49b), le circuit auxiliaire (52, 52a, 52b) comprenant un condensateur d'alimentation (53, 53a, 53b) et un condensateur auxiliaire (54), un commutateur à semi-conducteur auxiliaire à blocage automatique (55, 55a, 55b), une diode (56) et une diode de type bootstrap (57), dans lequel
- le commutateur à semi-conducteur auxiliaire (55, 55a, 55b) est connecté à une borne de potentiel de référence (59) du premier commutateur à semi-conducteur de puissance (6a) par l'intermédiaire d'un premier point de raccordement (58),
- à partir du premier point de raccordement (58), un montage en série de la diode (56), d'un deuxième point de raccordement (60) et du condensateur auxiliaire (54) est disposé en parallèle avec le commutateur à semi-conducteur auxiliaire (55, 55a, 55b), de sorte que, lorsque le commutateur à semi-conducteur auxiliaire (55, 55a, 55b) est bloqué, le condensateur auxiliaire (54) est chargé par le passage du courant à travers le premier commutateur à semi-conducteur de puissance (6a),
- le circuit d'attaque (49, 49a, 49b) est connecté au condensateur d'alimentation (53, 53a, 53b) pour son alimentation électrique, et
- le condensateur d'alimentation (53, 53a, 53b) est relié électriquement par une première borne (61) à la deuxième borne (60) par l'intermédiaire de la diode de type bootstrap (57) et par une deuxième borne (62) à la borne de potentiel de référence (59), de sorte que, lorsque le commutateur à semi-conducteur auxiliaire (55, 55a, 55b) est conducteur et que le condensateur auxiliaire (54) est au moins partiellement chargé, le condensateur d'alimentation (53, 53a, 53b) est chargé par le condensateur auxiliaire (54) par l'intermédiaire de la diode de type bootstrap (57), le circuit auxiliaire (52, 52a, 52b) comprenant un circuit de commande (64) qui est conçu et agencé pour fournir, en fonction d'une tension de charge du condensateur auxiliaire (54), un signal de commande pour commuter le commutateur à semi-conducteur auxiliaire (55, 55a, 55b) à une entrée de commande du commutateur à semi-conducteur auxiliaire (55, 55a, 55b).

2. Dispositif électronique de puissance (1a) selon la revendication 1, dans lequel le circuit de commande (64) est conçu et agencé pour fournir un signal de commande commutant le commutateur à semi-conducteur auxiliaire (55, 55a, 55b) à l'entrée de commande du commutateur à semi-conducteur auxiliaire (55, 55a, 55b) en cas de tension de charge du condensateur auxiliaire (54) dépassant une première valeur seuil, et, lorsque la tension de charge du condensateur auxiliaire (54) est inférieure à une deuxième valeur de seuil qui est inférieure à la première valeur de seuil, à fournir un signal de commande qui bloque le commutateur à semi-conducteur auxiliaire (55, 55a, 55b) à l'entrée de commande du commutateur à semi-conducteur auxiliaire (55, 55a, 55b), la première valeur de seuil correspondant au moins à la valeur d'une tension d'alimentation du circuit d'attaque (49, 49a, 49b).

3. Dispositif électronique de puissance (1a) selon l'une des revendications 1 ou 2, dans lequel le circuit de commande (64) est un régulateur à deux positions, notamment un circuit comparateur (65), ou une monoflop ou une régulation PWM ou une régulation de fréquence.

4. Dispositif électronique de puissance (1a) selon l'une des revendications 1 à 3, dans lequel le circuit de commande (64) est conçu et aménagé et relié électriquement au condensateur auxiliaire (54) de telle sorte que l'alimentation en tension électrique du circuit de commande (64) est réalisée au moyen du condensateur auxiliaire (54).

5. Dispositif électronique de puissance (1a) selon l'une quelconque des revendications précédentes, dans lequel le commutateur à semi-conducteur auxiliaire (55, 55a, 55b) présente la même polarité que le premier commutateur à semi-conducteur de puissance (6a).

6. Dispositif électronique de puissance (1a) selon l'une des revendications précédentes, dans lequel le premier commutateur à semi-conducteur de puissance (6a) est de type autobloquant et présente un courant de fuite à l'état bloqué de la commutation en présence d'une tension électrique entre la borne de potentiel de référence (59) et une autre borne principale (70) du premier commutateur à semi-conducteur de puissance (6a).

7. Dispositif électronique de puissance (1a) selon l'une des revendications précédentes, dans lequel le circuit auxiliaire (52, 52a, 52b), notamment le commutateur à semi-conducteur auxiliaire (55, 55a, 55b), sert exclusivement à alimenter au moins un circuit d'attaque (49, 49a, 49b, 73).

8. Dispositif électronique de puissance (1a) selon l'une des revendications précédentes, dans lequel le circuit d'attaque (49, 49a, 49b) est réalisé de manière intégrée avec une horloge (50), l'horloge (50) étant conçue pour générer un modèle d'impulsions du signal de commande fourni par le circuit d'attaque (49, 49a, 49b).

9. Dispositif électronique de puissance (1a) selon l'une quelconque des revendications précédentes, dans lequel est compris un demi-pont (20a, 20b) comprenant, à partir d'un troisième point de raccordement (21), un montage en série d'un commutateur à semi-conducteur de puissance côté haut (23a), un point de dérivation (39) et un commutateur à semi-conducteur de puissance côté bas (24a) et un quatrième point de raccordement (22), dans lequel le premier commutateur à semi-conducteur de puissance (6a) est le commutateur à semi-conducteur de puissance côté bas (24a), dans lequel, en particulier, le dispositif électronique de puissance (1a) est un régulateur DC/DC ou un onduleur (29), dans lequel, en option, un circuit intermédiaire (28) est compris avec une connexion électrique reliant le troisième point de raccordement (21) au quatrième point de raccordement (22) via un ou plusieurs condensateurs de circuit intermédiaire connectés en série ou en parallèle.

10. Dispositif électronique de puissance (1a) selon la revendication 9, dans lequel, soit pour le commutateur à semi-conducteur de puissance côté haut (23a), soit pour le commutateur à semi-conducteur de puissance côté bas (24a), respectivement un circuit d'attaque (49a, 49b) pour la commande du commutateur à semi-conducteur de puissance respectif et respectivement un circuit auxiliaire propre (52a, 52b) pour l'alimentation en tension électrique du circuit d'attaque (49a, 49b), de sorte qu'aussi bien le commutateur à semi-conducteur de puissance côté haut (23a) que le commutateur à semi-conducteur de puissance côté bas (24a) sont conçus comme un premier commutateur à semi-conducteur de puissance (6a), ou un circuit d'attaque (73) est compris pour la commande du commutateur semi-conducteur de puissance côté haut (23a) et un condensateur d'alimentation (74) est compris pour l'alimentation en tension électrique de ce circuit d'attaque (73), qui est relié électriquement par une borne (75) à une borne de potentiel de référence (59) du commutateur à semi-conducteur de puissance côté haut (23a) et qui est relié électriquement par une autre borne (76), par l'intermédiaire d'une autre diode de type bootstrap (77), à la première borne (61) du condensateur d'alimentation (53) compris dans le dispositif de circuit auxiliaire (52) pour l'alimentation en tension électrique du circuit d'attaque (49) pour la commande du commutateur à semi-conducteur de puissance côté bas (24a).

11. Dispositif électronique de puissance (1a) selon l'une des revendications 9 ou 10, dans lequel le commutateur à semi-conducteur de puissance côté haut (23a) et le commutateur à semi-conducteur de puissance côté bas (24a) sont autobloquants et présentent un courant de fuite à l'état bloqué de la commutation en présence d'une tension électrique entre leur borne de potentiel de référence (59) et leur autre borne principale (70).

12. Procédé d'alimentation en tension électrique d'un circuit d'attaque (49) d'un commutateur à semi-conducteur de puissance, le circuit d'attaque (49, 49a, 49b) étant alimenté en tension par un condensateur d'alimentation (53, 53a, 53b), dans lequel, pour charger le condensateur d'alimentation (53, 53a, 53b), un condensateur auxiliaire (54) est chargé au moyen d'un courant circulant à travers le commutateur à semi-conducteur de puissance pendant un état de commutation bloqué d'un commutateur auxiliaire à blocage automatique et le condensateur d'alimentation (53) est chargé par le condensateur auxiliaire (54) lorsque le commutateur auxiliaire à blocage automatique est commuté, le commutateur auxiliaire étant commuté en fonction d'une tension de charge du condensateur auxiliaire (54).

13. Procédé selon la revendication 12, dans lequel l'interrupteur auxiliaire est commuté lorsqu'une tension de charge du condensateur auxiliaire (54) dépasse une première valeur de seuil (VS2) et l'interrupteur auxiliaire est bloqué lorsque la tension de charge du condensateur auxiliaire (54) est inférieure à une deuxième valeur de seuil, la deuxième valeur de seuil étant inférieure à la première valeur de seuil (VS3).

14. Procédé selon l'une des revendications 12 ou 13, dans lequel le commutateur auxiliaire autobloquant est connecté à une borne de potentiel de référence (59) du semi-conducteur de puissance, de sorte que, dans une première étape du procédé (VS1), lorsque le commutateur auxiliaire est bloqué, au moins une partie du courant passant par le commutateur à semi-conducteur de puissance est déviée vers le condensateur auxiliaire et charge au moins partiellement ce dernier, dans une deuxième étape (VS2) du procédé, on fait passer le commutateur auxiliaire et on transfère au moins une partie de la charge du condensateur auxiliaire au condensateur d'alimentation, et dans une troisième étape (VS3) du procédé, on fait repasser le commutateur auxiliaire dans un état de commutation bloqué, de sorte qu'en répétant plusieurs fois les trois étapes du procédé, on fournit une puissance électrique au condensateur d'alimentation pour alimenter le circuit de commande en fonctionnement.

15. Procédé selon l'une des revendications 12 à 14, dans lequel le procédé est mis en oeuvre avec un dispositif électronique de puissance (1a) selon l'une des revendications 1 à 11.
